# EUROPEAN PATENT APPLICATION

(11) **EP 3 608 377 A1**
(43) Date of publication of application: **12.02.2020**
(21) Application number: 19771346.4
(22) Date of filing: 07.01.2019
(51) Int. Cl.: C09D 179/08, C08K 5/17, C08L 27/12, C08L 79/08, C09D 5/02, C09D 123/28, C09D 127/12

(54) **AQUEOUS TREATMENT AGENT, METHOD FOR PRODUCING AQUEOUS TREATMENT AGENT, AND METHOD OF USING AQUEOUS TREATMENT AGENT**

(30) Priority: 20.03.2018 JP 2018052931
(71) Applicant: Nakata Coating Co., Ltd., Yokohama-shi, Kanagawa 240-0041 (JP)
(72) Inventor: MATSUNO Takemi, Yokohama-shi, Kanagawa 240-0041 (JP); KITAGAWA Katsuji, Yokohama-shi, Kanagawa 240-0041 (JP); HANAZONO Misao, Yokohama-shi, Kanagawa 240-0041 (JP); SHIMOZAWA Okura, Yokohama-shi, Kanagawa 240-0041 (JP)
(74) Representative: Patentanwälte Bressel und Partner mbB
(86) International application number: PCT/JP2019/000065
(87) International publication number: WO 2019/181145

(57) **Abstract**

[Object] Provided is an aqueous treatment agent having a satisfactory environmental safety and aqueous solution stability, with which satisfactory surface modification properties are obtained for various molded articles and the like.

[Solving Means] An aqueous treatment agent including an imide group-containing compound derived from an imide group-containing compound obtained by partially hydrolyzing a polyimide molded article; a fluororesin-containing aqueous dispersion liquid; and an amine compound, in which an incorporation amount of a fluororesin included in the fluororesin-containing aqueous dispersion liquid is adjusted to a value within the range of 0.1 to 10,000 parts by weight, in terms of solid content, with respect to 100 parts by weight of an imide group-containing compound included in the imide group-containing compound.

## Description

### TECHNICAL FIELD

The present invention relates to an aqueous treatment agent, a method for producing an aqueous treatment agent, and a method for using an aqueous treatment agent.

Particularly, the invention relates to an aqueous treatment agent having an excellent environmental safety and a solution stability and having an excellent adhesiveness to various agents to be treated; an efficient method for producing such an aqueous treatment agent; and a method for using such an aqueous treatment agent.

### BACKGROUND ART

Conventionally, polyimide molded articles typified by a polyimide film have an excellent chemical resistance, and therefore, polyimide molded articles are insoluble in various solvents and have high melting points. Thus, it has been difficult to melt and reutilize polyimide molded articles as in the case of thermoplastic plastics such as polystyrene. Accordingly, in the case of disposing of polyimide molded articles and the like, although the molded articles are expensive, most of them are disposed of by landfill or incineration, and there has been a problem that polyimide molded articles have a poor recyclability and environmental characteristics.

Thus, various methods of recycling polyimide resins and the like by chemically hydrolyzing polyimide molded articles to be disposed of have been proposed. For example, it has been proposed that an aromatic polyimide molded article is completely hydrolyzed under predetermined temperature conditions in the co-presence of an alkali at a predetermined concentration, and thereby an aromatic tetracarboxylic acid dianhydride and an aromatic diamine as raw materials are obtained (see Patent Document 1).

Furthermore, the applicant has proposed a low temperature-curable imide group-containing compound that can be cured at low temperature and has an excellent solubility and an adhesiveness, by employing an imide group-containing compound having a particular structure that has a predetermined absorption peak in an infrared spectroscopic spectral chart obtainable in a case in which a polyimide molded article is recycled and then partially hydrolyzed and is analyzed by infrared spectroscopy (see Patent Document 2).

Furthermore, the applicant has also proposed an imide group-containing compound composition in which the increase of viscosity is suppressed to a low level even in a solution state, the composition including an imide group-containing compound that is obtained by recycling and then partially hydrolyzing a polyimide molded article and has a particular structure having a predetermined infrared absorption peak, together with a solvent and a viscosity stabilizer (see Patent Document 3).

### CITATION LIST

### PATENT DOCUMENT

Patent Document 1: JP 60-81154 A (claims and the like)
Patent Document 2: JP 5627735 B2 (claims and the like)
Patent Document 3: JP 5697805 B1 (claims and the like)

### SUMMARY OF THE INVENTION

### PROBLEM TO BE SOLVED BY THE INVENTION

However, the method for regenerating a polyimide molded article of Patent Document 1 and the like basically allows complete hydrolyzation of a polyimide molded article and deposition of an aromatic tetracarboxylic acid dianhydride and an aromatic diamine, and a main purpose of the methods lies in separating and collecting those compounds and obtaining a polyimide raw material or a residual metal material. Therefore, only the production of a regenerated polyimide resin is considered for a collected polyimide raw material and the like, and nothing has been considered in view of incorporating a fluororesin-containing aqueous dispersion liquid into the polyimide raw material and the like and then treating a fluororesin with a primer.

Furthermore, in Patent Document 2 and Patent Document 3, it is described in the light that N-methylpyrrolidone is used as a solvent, and also, an imide group-containing compound having a particular structure may be generally mixed with various resins including a fluororesin and the like. However, nothing has been considered from the viewpoint that when an imide group-containing compound having a particular structure is mixed with a fluorine-containing aqueous dispersion liquid at particular proportions, surface modification of a polyimide resin molded article is achieved, and a circuit board for use at high frequencies or the like can be constructed. Furthermore, nothing has been considered in view of being used for a primer treatment instead of conventionally used surface treatments such as a chrome treatment, and in view of providing fluororesin-coated molded articles such as frying pan. That is, it could not be thought of that in a case in which an aqueous treatment agent is configured by mixing an imide group-containing compound and a fluororesin-containing aqueous dispersion liquid at particular proportions, excellent environmental safety, aqueous solution stability, and the like may be obtained, and the imide group-containing compound and the fluororesin would appropriately undergo phase separation at the time of use and exhibit satisfactory adhesiveness or the like to a polyimide resin, iron, or the like.

Thus, the inventors of the present invention conducted a thorough investigation, and as a result, the inventors found that when a phase separation phenomenon between an imide group-containing compound having a particular structure and a fluororesin included in a predetermined fluororesin-containing aqueous dispersion liquid is utilized, satisfactory environmental safety or aqueous solution stability is obtained, and satisfactory adhesiveness or primer treatability can be exhibited with respect to various resin molded articles including polyimide resin molded articles and fluororesin molded articles, as well as metals and the like. Thus, the inventors completed the present invention. That is, according to the present invention, it is an object of the invention to provide an aqueous treatment agent derived from an imide group-containing compound, a fluororesin-containing aqueous dispersion liquid, and an amine compound, the aqueous treatment agent having satisfactory environmental safety or aqueous solution stability, being easily handleable, and being capable of exhibiting satisfactory adhesiveness or the like to various resin molded articles, metals, and the like; and to provide an efficient method for producing the aqueous treatment agent and a method for using the aqueous treatment agent.

### MEANS FOR SOLVING PROBLEM

According to the present invention, there is provided an aqueous treatment agent including an imide group-containing compound obtained by partially hydrolyzing a polyimide molded article, a fluororesin-containing aqueous dispersion liquid, and an amine compound, in which the fluororesin-containing aqueous dispersion liquid is incorporated such that an incorporation amount of a fluororesin included in the fluororesin-containing aqueous dispersion liquid is adjusted to a value within the range of 0.1 to 10,000 parts by weight, in terms of solid content, with respect to 100 parts by weight of the imide group-containing compound, and an incorporation amount of the amine compound is adjusted to a value within the range of 0.1 to 30 parts by weight with respect to 100 parts by weight of the imide group-containing compound. Thus, the problems described above can be solved.

As such, by incorporating an imide group-containing compound, a fluororesin-containing aqueous dispersion liquid, and an amine compound at predetermined proportions in terms of solid content, satisfactory aqueous liquid stability or environmental safety can be obtained. More specifically, for example, particularly, no precipitate is found under storage conditions of room temperature to 40°C for 3 months, and the viscosity increase is also three times or less the value of the initial viscosity. Furthermore, basically, the water content is large, and thus, the aqueous treatment agent corresponds to a non-hazardous material according to the fire services act. Furthermore, when the aqueous treatment agent is applied on a base material or the like and then is subjected to a predetermined heating treatment, the imide group-containing compound included in the imide group-containing compound and the fluorine-based resin included in the fluororesin-containing aqueous dispersion liquid undergo phase separation remarkably, and a surface treatment film (including a primer layer or the like; hereinafter, the same) thus obtainable can exhibit satisfactory adhesiveness or the like to various resin molded articles including polyimide resin molded articles or fluororesin molded articles, as well as metals and the like. Meanwhile, according to the present invention, a composition formed by incorporating a predetermined amount of an amine compound into an imide group-containing compound as such may be referred to as aqueous imide group-containing compound. That is, before a predetermined amount of an amine compound is incorporated, the imide group-containing compound may exhibit poor solubility; however, the imide group-containing compound becomes markedly soluble by incorporating a predetermined amount of such an amine compound. Therefore, the imide group-containing compound is referred to as aqueous imide group-containing compound.

Furthermore, on the occasion of configuring the aqueous treatment agent of the present invention, it is preferable that the boiling point (under atmospheric pressure; hereinafter, the same) of the amine compound is adjusted to a value within the range of 50°C to 350°C.

As such, by incorporating an amine compound having a predetermined boiling point, when the aqueous treatment agent is heated under predetermined conditions, the aqueous treatment agent can be sufficiently scattered, and heat resistance, electrical characteristics, and the like of the predetermined surface treatment film thus obtainable can be improved.

Furthermore, on the occasion of configuring the aqueous treatment agent of the present invention, it is preferable that the fluororesin-containing aqueous dispersion liquid includes particles of the fluororesin, and the average particle size of the fluororesin particles is adjusted to a value within the range of 0.01 to 10 µm.

As such, when the average particle size (median diameter, D50) of the fluororesin particles is adjusted to a value within a predetermined range, the aqueous solution stability in the aqueous treatment agent thus obtained can be further improved, and the phase separation between the fluororesin particles and the imide group-containing compound occurs in a more remarkable way and readily, while the adhesiveness to various objects to be treated and the like can be further increased.

Furthermore, on the occasion of configuring the aqueous treatment agent of the present invention, it is preferable that the fluororesin-containing aqueous dispersion liquid includes a surfactant, and an incorporation amount of the surfactant is adjusted to a value within the range of 0.01% to 10% by weight with respect to the total amount of the fluororesin-containing aqueous dispersion liquid.

By incorporating a surfactant in a predetermined amount as such, the aqueous solution stability could be further improved, and also, an aqueous treatment agent that exhibits more satisfactory surface coatability and the like to various objects to be treated could be obtained.

Furthermore, on the occasion of configuring the aqueous treatment agent of the present invention, it is preferable that the imide group-containing compound has, in an infrared spectroscopic spectral chart obtainable in the case of analyzing the imide group-containing compound by infrared spectroscopy, an absorption peak originating from an imide group at a wave number of 1,375 cm⁻¹, an absorption peak originating from an amide group at a wave number of 1,600 cm⁻¹, and an absorption peak originating from a carboxyl group at a wave number of 1,413 cm⁻¹.

When such an imide group-containing compound is used, the imide group-containing compound has excellent solubility in a water-soluble solvent (water, an alcohol, or the like), and the imide group-containing compound can be reliably subjected to a curing reaction in a short time period even under heating at relatively low temperature, so that a typical polyimide resin can be obtained. Furthermore, when such an imide group-containing compound is used, the imide group-containing compound can be widely mixed with the fluororesin-containing aqueous dispersion liquid, and phase separation between the imide group-containing compound and the fluororesin critically could occur.

Furthermore, on the occasion of configuring the aqueous treatment agent of the present invention, it is preferable that the imide group-containing compound includes at least one of an ortho-formic acid ester compound, a phytic acid compound, a Dacrotized compound, and EDTA as a viscosity stabilizer, and an incorporation amount of the viscosity stabilizer is adjusted to a value within the range of 0.01% to 20% by weight with respect to the total amount of the imide group-containing compound.

As such, by incorporating a predetermined amount of a particular viscosity stabilizer, the viscosity increase of the aqueous treatment agent during storage could be efficiently suppressed. Therefore, the aqueous solution stability of the aqueous treatment agent thus obtainable could be further improved, and, an adhesiveness, a surface coatability, and the like to various objects to be treated, metals, and the like could be exhibited more reliably and stably.

Another embodiment of the present invention is a method for producing an aqueous treatment agent including an imide group-containing compound obtained by partially hydrolyzing a polyimide molded article, a fluororesin-containing aqueous dispersion liquid, and an amine compound, the method including the following steps (1) to (3) :
(1) a step of preparing, as a first solution, a solution of the imide group-containing compound (also referred to as amine solution) by incorporating an aqueous solvent in an amount adjusted to a value within the range of 0.1 to 30 parts by weight, in terms of solid content, with respect to 100 parts by weight of the imide group-containing compound, and incorporating the amine compound in an amount adjusted to a value within the range of 0.1 to 30 parts by weight, in terms of solid content, with respect to 100 parts by weight of the imide group-containing compound;
(2) a step of preparing a fluororesin-containing aqueous dispersion liquid as a second solution; and
(3) a step of mixing the first solution and the second solution such that an incorporation amount of a fluororesin included in the second solution is adjusted to a value within the range of 0.1 to 10,000 parts by weight, in terms of solid content, with respect to 100 parts by weight of the imide group-containing compound included in the first solution, and obtaining an aqueous treatment agent.

As such, by mixing an amine solution of an imide group-containing compound with a fluororesin-containing aqueous dispersion liquid at predetermined proportions in terms of solid content, an aqueous treatment agent having satisfactory environmental safety and aqueous solution stability could be obtained. Furthermore, by applying the aqueous treatment agent on a base material or the like and then performing a predetermined heating treatment, the imide group-containing compound included in the imide group-containing compound and the fluorine-based resin included in the fluororesin-containing aqueous dispersion liquid undergo phase separation in a critical way, and thereby a surface treatment film that exhibits satisfactory adhesiveness or the like to various resin molded articles, metals, and the like could be formed. Meanwhile, although the extent may vary depending on the boiling point of the amine compound, there are occasions in which a portion of the amine compound reacts with the imide group-containing compound and remains; however, most of the amine compound is scattered by performing a predetermined heating treatment.

Furthermore, still another embodiment of the present invention is a method for using an aqueous treatment agent including an imide group-containing obtained by partially hydrolyzing a polyimide molded article, a fluororesin-containing aqueous dispersion liquid, and an amine compound, the method including the following steps (1') to (3') :
(1') a step of preparing an aqueous treatment agent including an imide group-containing compound obtained by partially hydrolyzing a polyimide molded article, a fluororesin-containing aqueous dispersion liquid, and an amine compound, the aqueous treatment agent being obtained by adjusting an incorporation amount of a fluororesin included in the fluororesin-containing aqueous dispersion liquid to a value within the range of 0.1 to 10,000 parts by weight, in terms of solid content, with respect to 100 parts by weight of the imide group-containing compound, and adjusting the incorporation amount of the amine compound to a value within the range of 0.1 to 30 parts by weight with respect to 100 parts by weight of the imide group-containing compound;
(2') a step of laminating the aqueous treatment agent on the surface of a material to be treated; and
(3') a step of heating the aqueous treatment agent laminated on the surface of the material to be treated, to a temperature of 200°C or higher, and thereby obtaining a surface treatment film.

As such, when an imide group-containing compound, a fluororesin-containing aqueous dispersion liquid, and an amine compound are incorporated in step (1') at predetermined proportions in terms of solid content, an aqueous treatment agent having satisfactory environmental safety and aqueous solution stability could be obtained. Furthermore, when the aqueous treatment agent is laminated (applied) on a material to be treated in step (2'), and then the aqueous treatment agent is subjected to a predetermined heating treatment in step (3'), a predetermined surface treatment film (including a primer-treated layer or the like) could be obtained. That is, as the imide group-containing compound and the fluorine-based resin and the like undergo phase separation in a critical way, predetermined water repellency, anti-pollution characteristics, and the like could be obtained starting from a polyimide resin molded article or a fluororesin molded article, and also, satisfactory adhesiveness and the like to various resin molded articles, metals, and the like could be exhibited.

### BRIEF DESCRIPTION OF DRAWINGS

Figs. 1(a) to 1(d) are diagrams provided in order to describe a configuration example of a polyimide resin-molded article or the like formed by surfacing the molded article using an aqueous treatment agent;
Fig. 2 is an FT-IR chart obtained before curing of an exemplary imide group-containing compound;
Fig. 3 is an FT-IR chart obtained after curing of an exemplary imide group-containing compound;
Figs. 4(a) and 4(b) are FT-IR charts respectively obtained before curing and after curing of an aqueous treatment agent (separate imide group-containing compound = 100%) ;
Figs. 5(a) and 5(b) are FT-IR charts respectively obtained before curing and after curing of an aqueous treatment agent (separate imide group-containing compound/fluororesin = weight ratio 9/1);
Figs. 6(a) and 6(b) are FT-IR charts respectively obtained before curing and after curing of an aqueous treatment agent (separate imide group-containing compound/fluororesin = weight ratio 7/3);
Figs. 7(a) and 7(b) are FT-IR charts respectively obtained before curing and after curing of an aqueous treatment agent (separate imide group-containing compound/fluororesin = weight ratio 5/5);
Figs. 8(a) and 8(b) are FT-IR charts respectively obtained before curing and after curing of an aqueous treatment agent (separate imide group-containing compound/fluororesin = weight ratio 3/7);
Figs. 9(a) and 9(b) are FT-IR charts respectively obtained before curing and after curing of an aqueous treatment agent (fluororesin = weight ratio 100%);
Fig. 10 is a diagram provided to describe the influence exerted by the mixing proportions of a fluororesin and an imide group-containing compound included in an aqueous treatment agent on the surface tension in a surface-modified film obtainable from the aqueous treatment agent; and
Figs. 11(a) to 11(d) are diagrams provided to describe a method for using an aqueous treatment agent.

### MODES FOR CARRYING OUT THE INVENTION

### [First embodiment]

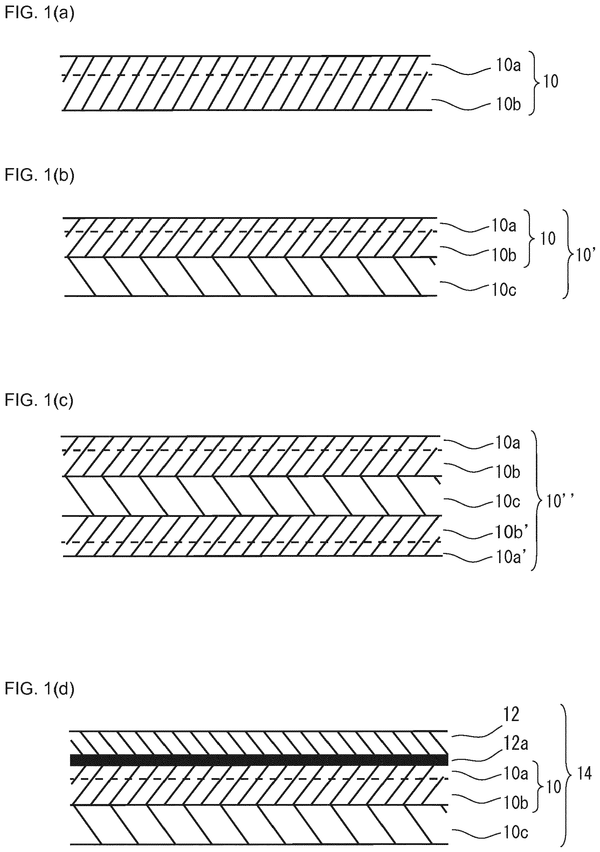

A first embodiment is an aqueous treatment agent including an imide group-containing compound obtained by partially hydrolyzing a polyimide molded article, a fluororesin-containing aqueous dispersion liquid, and an amine compound, in which the fluororesin-containing aqueous dispersion liquid is incorporated such that the incorporation amount of a fluororesin included in the fluororesin-containing aqueous dispersion liquid is adjusted to a value within the range of 0.1 to 10,000 parts by weight, in terms of solid content, with respect to 100 parts by weight of the imide group-containing compound, and the incorporation amount of the amine compound is adjusted to a value within the range of 0.1 to 30 parts by weight with respect to 100 parts by weight of the imide group-containing compound. In the following description, each and every constituent element for the aqueous treatment agent of the first embodiment will be specifically described. Furthermore, configuration examples of a polyimide resin molded article that is surface-treated using the aqueous treatment agent of the first embodiment (simple material of a surface treatment film 10, a polyimide film 10' for a single-sided high-frequency circuit, a polyimide film 10" for a double-sided high-frequency circuit, and a single-sided high-frequency circuit board 14) will also be specifically described with reference to Figs. 1(a) to 1(d).

### 1. Imide group-containing compound (aqueous imide group-containing compound)

### (1) Polyimide molded article

On the occasion of obtaining a predetermined imide group-containing compound by performing partial hydrolysis, polyimide molded articles (recycled articles) that have been conventionally treated as industrial waste materials widely serve as raw materials. Therefore, suitable examples of the polyimide molded articles include a film made of polyimide, a polyimide coating film, a resist made of polyimide, an electrical component housing made of polyimide, an electronic component material made of polyimide, a container made of polyimide, a machine part made of polyimide, and an automotive part made of polyimide.

Furthermore, a circuit board having metal circuit pattern formed on a polyimide film surface, and a composite laminate such as a TAB tape could also be used, after the metal circuit pattern is removed, as the polyimide molded articles as raw materials to be used at the time of producing the imide group-containing compound of the present invention. In addition to that, from the viewpoint that a recycling treatment could be omitted, and the product quality or reactivity is more stabilized, an unused polyimide molded article (non-recycled article) including a polyimide film or a polyimide resin, which has been produced particularly in order to obtain an imide group-containing compound appropriate for the present invention by performing hydrolysis immediately after production, is also suitable.

### (2) Partial hydrolysate

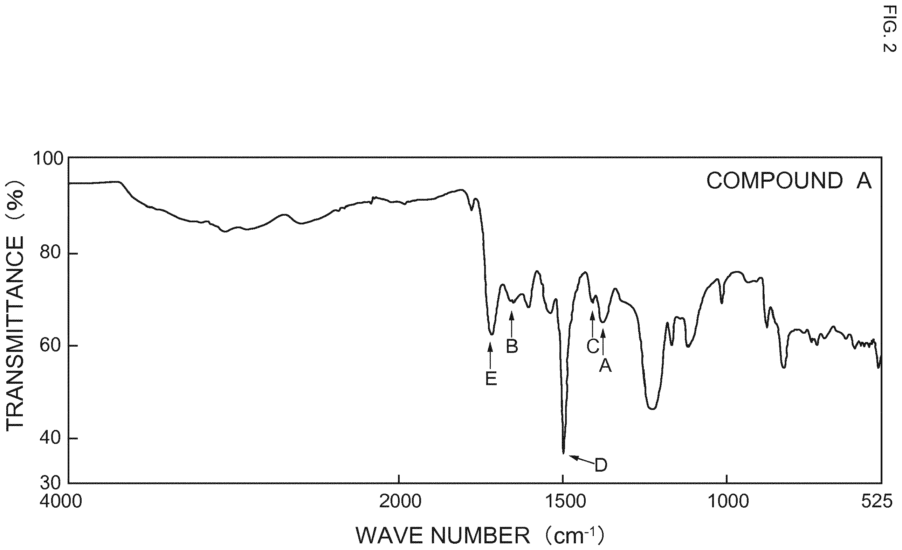

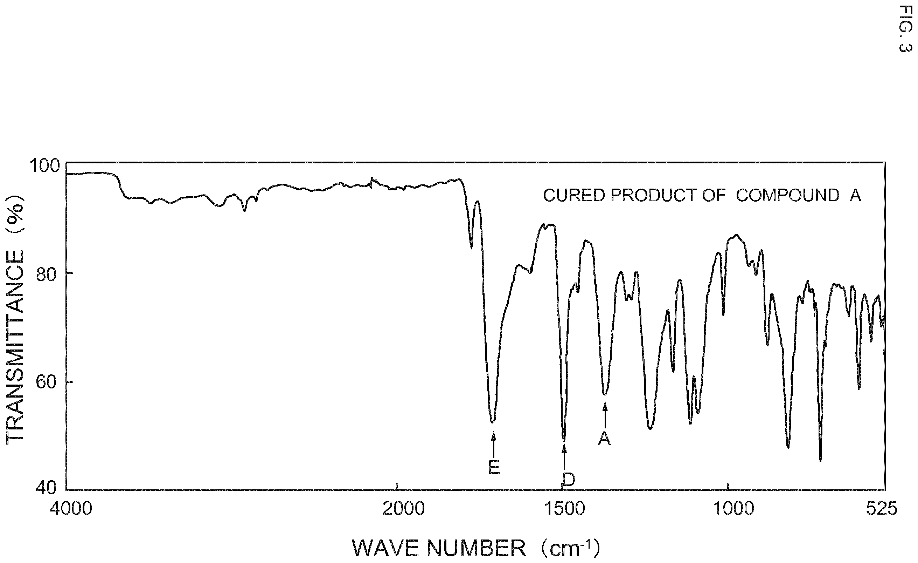

As an example of an infrared spectroscopic spectral chart obtainable before curing is shown in Fig. 2, and an example of an infrared spectroscopic spectral chart obtainable after curing is shown in Fig. 3, the predetermined imide group-containing compound is a partial hydrolysate of a polyimide molded article having a predetermined structure. That is, an imide group-containing compound obtainable by partially hydrolyzing a polyimide molded article having a predetermined size in the presence of water and a basic compound, for example, under temperature conditions of 50°C to 100°C, the imide group-containing compound having a predetermined structure represented by the following Formula (1), serves as the predetermined imide group-containing compound. Therefore, by having at least an imide group, an amide group, and a carboxyl group or a carbonyl group in a molecule composed of carbon atoms or the like, an imide group-containing compound that could be cured at relatively low temperature and exhibits satisfactory solubility in various organic solvents and satisfactory adhesiveness to various undercoats could be used. 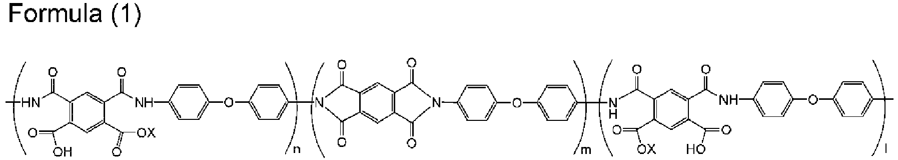 wherein in Formula (1), symbol X represents an alkali metal (lithium/Li, sodium/Na, potassium/K, rubidium/Rb, or cesium/Ce); subscripts n and 1 are symbols each representing the amount of existence (number of moles) of a polyamic acid structure positioned on both sides of a polyimide structure and usually have a value within the range of 0.1 to 0.8; and subscript m is a symbol representing the amount of existence (number of moles) of the polyimide structure and usually has a value within the range of 0.2 to 0.9.

Furthermore, regarding the molecular terminals of the imide group-containing compound, it is speculated that the molecular terminals have a predetermined structure represented by the following Formula (2). That is, it is speculated that a polyamic acid structure as represented by symbol A, a mixture of polyamic acid and an alkali soap structure as represented by symbol B, and an alkali soap structure as represented by symbol C form the molecular terminal structures each alone or in combination. Therefore, when such a molecular terminal is employed, an imide group-containing compound that could be cured at lower temperature and exhibits superior solubility in various organic solvents and superior adhesiveness could be obtained.

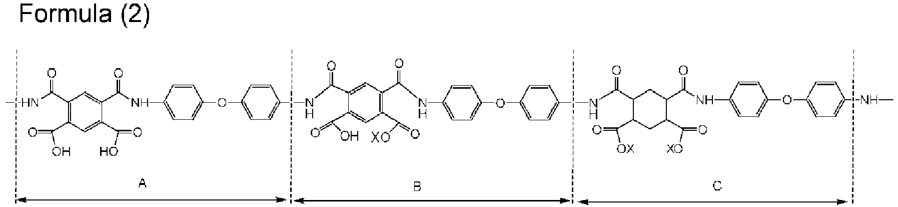

However, it is not necessarily essential for the imide group-containing compound to include an imide group, an amide group, and a carboxyl group simultaneously in one molecule composed of carbon atoms, and the imide group-containing compound may be a mixture of a polyimide having an imide group represented by the following Formula (3)-1, a polyamic acid having an amide group represented by the following Formula (3)-2, and a carboxylic acid compound having a carboxyl group represented by the following Formula (3)-3.

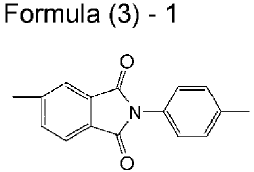

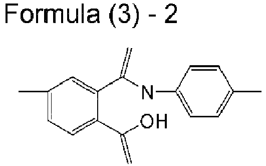

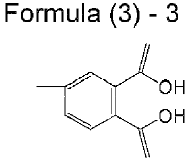

Furthermore, the predetermined imide group-containing compound has a feature of having an absorption peak originating from an imide group at a wave number of 1,375 cm⁻¹ or in the vicinity thereof in an infrared spectroscopic spectral chart obtainable when the predetermined imide group-containing compound is analyzed by infrared spectroscopy. The reason for this is that by having such an imide group in the molecule, an imide group-containing compound that could be cured at lower temperature could be obtained, and further, in a case in which the imide group-containing compound is converted to a macromolecule by a thermal curing treatment to become a polyimide resin, the polyimide resin could exhibit predetermined heat resistance.

The amount of imide groups (peak height) in the predetermined imide group-containing compound could be used as an index representing the extent of partial hydrolysis, and it has been found that when the amount of imide groups (peak height) in an infrared spectroscopic spectral chart of the polyimide formed by thermal curing is designated as 100, it is preferable to adjust the amount of imide groups of the predetermined imide group-containing compound in the range of 10 to 50, more preferably in the range of 15 to 45, and still more preferably in the range of 20 to 40. In addition to that, since the imide group-containing compound has an absorption peak originating from an imide group at a wave number of 1,770 cm⁻¹ or in the vicinity thereof, this could be utilized, together with the above-mentioned absorption peak, as a reference to determine whether an imide group is present.

The predetermined imide group-containing compound has a feature of having an absorption peak originating from an amide group at a wave number of 1,600 cm⁻¹ or in the vicinity thereof. The reason for this is that by having such an amide group in the molecule, an imide group-containing compound that could be cured at lower temperature could be obtained.

Furthermore, the predetermined imide group-containing compound has a feature of having an absorption peak originating from a carboxyl group at a wave number of 1,413 cm⁻¹ or in the vicinity thereof. The reason for this is that by having such a carboxyl group in the molecule, an imide group-containing compound having satisfactory solubility and adhesiveness could be obtained. Furthermore, it is preferable that the predetermined imide group-containing compound has an absorption peak originating from a carbonyl group at a wave number of 1,710 cm⁻¹ or in the vicinity thereof. The reason for this is that by having such a carbonyl group in the molecule, an imide group-containing compound having more satisfactory solubility could be obtained.

### (3) Ratio of S1/S2

Furthermore, in an infrared spectroscopic spectral chart of the predetermined imide group-containing compound, when the height of an absorption peak (peak D) originating from a benzene ring at a wave number of 1,500 cm⁻¹ is designated as S1, and the height of an absorption peak (peak A) originating from an imide group at a wave number of 1,375 cm⁻¹ is designated as S2, it is preferable that the ratio of S1/S2 is adjusted to a value within the range of 2 to 10. The reason for this is that by defining the existence proportion of imide groups as such, an imide group-containing compound that could be cured at lower temperature could be obtained, and the existence proportion could be used as an index representing the extent of partial hydrolysis. Therefore, it is more preferably to adjust the ratio of S1/S2 to a value within the range of 3 to 8, and it is still more preferably to adjust the ratio of S1/S2 to a value within the range of 5 to 7.

### (4) Ratio of S1/S3

In an infrared spectroscopic spectral chart of the predetermined imide group-containing compound, when the height of an absorption peak (peak D) originating from a benzene ring at a wave number of 1,500 cm⁻¹ is designated as S1, and the height of an absorption peak (peak B) originating from an amide group at a wave number of 1,600 cm⁻¹ is designated as S3, it is preferable that the ratio of S1/S3 is adjusted to a value within the range of 2 to 20.

The reason for this is that by defining the existence proportion of amide groups as such, an imide group-containing compound having superior solubility in water or a predetermined organic solvent and having superior adhesiveness to an object to be treated could be obtained, and also, the existence proportion could be utilized as an index representing the extent of partial hydrolysis. Therefore, it is more preferably that the ratio of S1/S3 is adjusted to a value within the range of 5 to 15, and it is still more preferably that the ratio of S1/S3 is adjusted to a value within the range of 7 to 12.

### (5) Ratio of S1/S4

In an infrared spectroscopic spectral chart of the predetermined imide group-containing compound, when the height of an absorption peak (peak D) originating from a benzene ring at a wave number of 1,500 cm⁻¹ is designated as S1, and the height of an absorption peak (peak C) originating from a carboxyl group at a wave number of 1,413 cm⁻¹ is designated as S4, it is preferable that the ratio of S1/S4 is adjusted to a value within the range of 8 to 30. The reason for this is that by defining the existence proportion of carboxyl groups as such, an imide group-containing compound having superior solubility in a predetermined organic solvent and superior adhesiveness could be obtained, and the existence proportion could be utilized as an index representing the extent of partial hydrolysis. Therefore, it is more preferably that the ratio of S1/S4 is adjusted to a value within the range of 10 to 25, and it is still more preferably that the ratio of S1/S4 is adjusted to a value within the range of 13 to 20.

### (6) Weight average molecular weight

Furthermore, it is preferable that the weight average molecular weight of the predetermined imide group-containing compound is adjusted to a value within the range of 1,000 to 100,000. The reason for this is that when such a weight average molecular weight is employed, predetermined low-temperature curability is obtained, and also, satisfactory solubility in organic solvents is obtained. Therefore, it is more preferably that the weight average molecular weight of the imide group-containing compound to a value within the range of 3,000 to 60,000, and still more preferably to a value within the range of 5,000 to 30,000. Such a weight average molecular weight of the imide group-containing compound could be measured by gel permeation chromatography as a molecular weight calculated relative to polystyrene standards.

### (7) Particles

The imide group-containing compound may be used directly after being hydrolyzed; however, it is preferable that the imide group-containing compound is made into a particulate form before being dissolved in an aqueous solvent (water or the like), and the average particle size of the particles is adjusted to a value within the range of 0.1 to 500 µm. The reason for this is that when the imide group-containing compound is configured as such, satisfactory handleability and storability are obtained, and an imide group-containing compound having superior solubility in water or a predetermined solvent could be obtained. Therefore, it is more preferably that the average particle size (median diameter, D50) of the particles of the imide group-containing compound is adjusted to a value within the range of 5 to 100 µm, and still more preferably to a value within the range of 10 to 50 µm. Meanwhile, the average particle size of the particles of the imide group-containing compound could be measured according to JIS Z8901:2006 using a micrometer, a laser particle size analyzer, an image analysis means, or the like.

### (8) Characteristics of imide group-containing compound

Regarding the imide group-containing compound, it is preferable that an aqueous solvent including water or an alcohol is used as a solvent, and the incorporation amount of the aqueous solvent is usually adjusted to a value within the range of 0.01% to 25% by weight with respect to the total amount of the imide group-containing compound. The reason for this is that when such an imide group-containing compound is in a state of an aqueous solution of the imide group-containing compound, handling is made easier, and a more uniform aqueous treatment agent could be obtained by mixing the imide group-containing compound with a fluororesin-containing aqueous dispersion liquid at accurate proportions. Furthermore, since the imide group-containing compound is dissolved in a shorter time period, it is also preferable to use an aqueous solvent that is obtained by dissolving a portion or the entirety of an amine compound in advance in water, an alcohol or the like as an aqueous solvent (the concentration of the amine compound is, for example, 0.1% to 10% by weight).

### 2. Fluororesin-containing aqueous dispersion liquid

### (1) Type of fluororesin

The type of the fluororesin that is included in the fluororesin-containing aqueous dispersion liquid is not particularly limited; however, the fluororesin is preferably at least one of polytetrafluoroethylene (PTFE), polyvinylidene fluoride (PVDE), polyhexafluoropropylene (HFP), perfluoropropyl vinyl ether (PPVE), chlorotrifluoroethylene (CTFE), a tetrafluoroethylene-perfluoroalkyl vinyl ether copolymer (PFA), or the like. Furthermore, among these fluororesins, from the viewpoints of being relatively inexpensive, having excellent mixing dispersibility with the imide group-containing compound, easily undergoing phase separation when incorporated in a small amount, and having a high surface modification effect, a fluororesin including polytetrafluoroethylene (PTFE) as a main component is suitable. Moreover, a fluororesin obtained by introducing an amino group, a carboxyl group, a hydroxyl group, or the like into the molecule of a fluororesin as a main agent is also preferable.

### (2) Incorporation amount 1 of fluororesin

There is a feature that the incorporation amount of the fluororesin-containing aqueous dispersion liquid, that is, the incorporation amount of a fluororesin included in the fluororesin-containing aqueous dispersion liquid, is adjusted to a value within the range of 0.1 to 10,000 parts by weight, in terms of solid content, with respect to 100 parts by weight of the imide group-containing compound included in the imide group-containing compound. The reason for this is that when the incorporation amount of such a fluororesin-containing aqueous dispersion liquid (fluororesin) is excessively small, the effect of incorporation is not exhibited, and water repellency and the like attributed to the aqueous treatment agent may not be exhibited. Therefore, it is because in a case in which a polyimide film is used as an object to be treated, the water repellency at the surface of the polyimide film is not enhanced, and the high frequency characteristics and the like based on a decrease in the dielectric constant may not be enhanced. Meanwhile, it is because when the incorporation amount of such a fluororesin-containing aqueous dispersion liquid becomes excessive large, the mechanical strength of the object to be treated may be decreased, or heat resistance or low-temperature curability may become insufficient. Therefore, it is more preferably that the incorporation amount of the fluororesin included in the fluororesin-containing aqueous dispersion liquid is usually adjusted to a value within the range of 1 to 5,000 parts by weight, and more preferably to a value within the range of 10 to 500 parts by weight, in terms of solid content, with respect to 100 parts by weight of the imide group-containing compound included in the imide group-containing compound.

### (3) Incorporation amount 2 of fluororesin

Furthermore, the incorporation amount may vary depending on the use; however, for example, assuming a high-frequency circuit board or the like using a polyimide film as an object to be treated, in a case in which surface modification of the polyimide film or the like is mainly considered, the incorporation amount of the fluororesin-containing aqueous dispersion liquid could be made into a relatively small amount. For example, it has been found that only by forming a surface-modified film by incorporating 5 parts by weight of a fluororesin with respect to 100 parts by weight of the imide group-containing compound, a polyimide film having a surface tension of 45 mN/m becomes a polyimide film including a surface-modified film having a surface tension of 23 mN/m. Therefore, in a case in which surface modification of a polyimide film or the like is mainly considered, it is more preferably that the incorporation amount of a fluororesin included in the fluororesin-containing aqueous dispersion liquid is adjusted to a value within the range of 0.1 to 80 parts by weight, still more preferably to a value within the range of 1 to 50 parts by weight, and still more preferably to a value within the range of 3 to 30 parts by weight, in terms of solid content, with respect to 100 parts by weight of the imide group-containing compound included in the imide group-containing compound.

In addition, regarding the use applications, for example, in a case in which a primer treatment for iron, aluminum, or the like as a fluororesin-coated base material such as a frying pan or a hot plate is considered, since the adhesiveness to a fluororesin coating becomes especially satisfactory, it can be said to be preferable to adjust the incorporation amount of the fluororesin-containing aqueous dispersion liquid to be relatively large. Therefore, in a case in which a primer treatment for iron or the like is considered, it is more preferably that the incorporation amount of the fluororesin included in the fluororesin-containing aqueous dispersion liquid is adjusted to a value within the range of more than 80 and less than or equal to 10,000 parts by weight, still more preferably to a value within the range of 150 to 5,000 parts by weight, and still more preferably to a value within the range of 200 to 1,000 parts by weight, in terms of solid content, with respect to 100 parts by weight of the imide group-containing compound included in the imide group-containing compound.

### (4) Average molecular weight of fluororesin

It is preferable that the average molecular weight (weight average molecular weight; hereinafter, the same) of the fluororesin included in the fluororesin-containing aqueous dispersion liquid is adjusted to a value of 600,000 or more. The reason for this is that when the average molecular weight (weight average molecular weight) of the fluororesin is below 600,000, in a case in which the aqueous treatment agent is heated and fused and then cooled, crystallization is not likely to occur, and a surface treatment film having gloss or transparency may not be obtained, or the adhesive force or mechanical strength of the surface treatment film to an undercoat may be excessively decreased. Therefore, it is preferable that the average molecular weight of the fluororesin is adjusted to a value within the range of 800,000 to 2,000,000, and more preferably to a value within the range of 1,000,000 to 1,500,000.

However, in a case in which the average molecular weight of the fluororesin is below 600,000, for example, even in the case of 100,000 to 550,000, the miscibility of the fluororesin with the imide group-containing compound may be improved, or depending on the heating method or the like, an aqueous treatment agent having gloss or transparency may be obtained.

### (5) Average particle size of fluororesin

It is preferable that the average particle size (median diameter, D50) of the particles of the fluororesin included in the fluororesin-containing aqueous dispersion liquid is adjusted to a value within the range of 0.01 to 10 µm. The reason for this is that by adjusting the average particle size of the fluororesin particles to a value within the predetermined range as such, the aqueous solution stability in the aqueous treatment agent could be further improved. Furthermore, it is because more satisfactory surface coatability and surface modification properties toward various materials to be treated are exhibited, and satisfactory adhesiveness is obtained.

More specifically, it is because when the average particle size of the particles of the fluororesin has a value of 0.01 µm, the surface coatability or surface modification properties toward various materials to be treated may be deteriorated, or it may be difficult to obtain satisfactory adhesiveness to various materials to be treated. On the other hand, when the average particle size of the particles of the fluororesin is above 10 µm, not only the stability of the fluororesin-containing aqueous dispersion liquid, but also the stability of the aqueous solution in the aqueous treatment agent is decreased, and clouding may occur, or particles of the fluororesin and the like may deposit. Therefore, it is more preferably that the average particle size (median diameter, D50) of the particles of the fluororesin is adjusted to a value within the range of 0.05 to 8 µm, and still more preferably to a value within the range of 0.1 to 5 µm. The average particle size (D50) of the particles of the fluororesin can be measured according to JIS Z 8901:2006, by measuring the particle sizes from the particles of a microscopic photograph using an image analyzer or the like, or by using a particle analyzer based on laser light.

### (6) Surfactant

It is preferable that a surfactant is incorporated into the fluororesin-containing aqueous dispersion liquid. That is, examples of the type of surfactant include an anionic surfactant, a cationic surfactant, and a nonionic surfactant; however, specific examples include an ammonium salt-based surfactant, an amine salt-based surfactant, a fluorine-based surfactant, a siloxane-based surfactant, and a polymeric surfactant. Particularly, when a nonionic surfactant is used, aggregation of fluororesin particles is effectively prevented by incorporation of a relatively small amount of the nonionic surfactant, and satisfactory aqueous solution stability could be obtained. Therefore, a nonionic surfactant is a suitable surfactant.

Furthermore, the incorporation amount of the surfactant may vary depending on the fluororesin-containing aqueous dispersion liquid with respect to the imide group-containing compound; however, it is preferable that the incorporation amount of the surfactant is adjusted to a value within the range of 0.01 to 20 parts by weight, in terms of solid content, with respect to the total amount of the aqueous treatment agent. The reason for this is that when the incorporation amount of the surfactant is excessively small, the aqueous solution stability in the fluororesin-containing aqueous dispersion liquid may be excessively deteriorated. On the other hand, it is because when the incorporation amount of the surfactant is excessively large, the curing latency may be deteriorated, or heat resistance or mechanical characteristics may become insufficient. Therefore, it is more preferably that the incorporation amount of the surfactant is adjusted to a value within the range of 0.1 to 10 parts by weight, and still more preferably to a value within the range of 0.5 to 5 parts by weight, in terms of solid content, with respect to the total amount of the aqueous treatment agent.

### (7) Viscosity of fluororesin-containing aqueous dispersion liquid

Furthermore, it is preferable that the viscosity of the fluororesin-containing aqueous dispersion liquid is adjusted to a value within the range of 10 to 50,000 mPa·sec (measurement temperature: 25°C, solid content: 60% by weight; hereinafter, the same). The reason for this is that by limiting the viscosity of the fluororesin-containing aqueous dispersion liquid to the predetermined range, handling is facilitated. In addition to that, it is because satisfactory storage stability is obtained, coatability is enhanced, and other components to be incorporated, for example, a thermoplastic resin component, a thermosetting resin component, a photocurable resin component, a metal material, and a ceramic material, can be mixed in uniformly and rapidly. Therefore, it is more preferably that the viscosity of the fluororesin-containing aqueous dispersion liquid is adjusted to a value within the range of 20 to 10,000 mPa·sec, and still more preferably to a value within the range of 30 to 5,000 mPa·sec.

### (8) Solvent of fluororesin-containing aqueous dispersion liquid

Regarding the type of the solvent of the fluororesin-containing aqueous dispersion liquid, it is basically preferable to employ water. The reason for this is that when water is used, and when water is heated to a temperature of at least 100°C or higher, or to a temperature of 150°C or higher, water is scattered readily and rapidly, and thereby water could be effectively prevented from remaining. Meanwhile, the fluororesin-containing aqueous dispersion liquid may be clouded; however, from the viewpoint of having satisfactory handleability, it is more suitable that the fluororesin-containing aqueous dispersion liquid is transparent, for example, the fluororesin-containing aqueous dispersion liquid has a visible light transmittance of 90% or higher.

### 3. Amine compound

### (1) Type 1

It is preferable that the type of the amine compound is determined in consideration of handleability, boiling point, and the like. Therefore, for example, at least one of diethylamine (boiling point: 55.5°C), triethylamine (boiling point: 89.5°C), and the like, and at least one of propylamine (boiling point: 49°C), dipropylamine (boiling point: 117°C), tripropylamine (boiling point: 156°C) , ethylpropylamine (boiling point: 83°C), butylamine (78°C), tributylamine (boiling point: 216°C), ethylbutylamine (boiling point: 125°C), pentylamine (boiling point: 103°C), hexylamine (boiling point: 131°), and the like, may be mentioned.

An amine compound having a branched alkyl group is also suitable, and specifically, at least one of isopropylamine (boiling point: 34°C), diisopropylamine (boiling point: 84°C), triisopropylamine (boiling point: 47°C), ethylisopropylamine, isobutylamine (boiling point: 69°C), diisobutylamine, tert-butylamine (boiling point: 46°C), di-sec-butylamine (boiling point: 135°C), dimethylaminoethanol (boiling point: 134°C), triisobutylamine (boiling point: 192°C), and the like may be mentioned.

An amine compound having an alicyclic structure could be suitably used, since an amine compound does not easily cause discoloration when heat-treated. Example include cyclohexylamine (boiling point: 134°C) and dicyclohexylamine (boiling point: 169°C).

Furthermore, examples of ethanolamine having a hydroxyalkyl group include diethanolamine (boiling point: 280°C), triethanolamine (boiling point: 335°C), N-methylethanolamine (boiling point: 160°C), propanolamine (boiling point: 160°C), isopropanolamine (boiling point: 159°C), diisopropanolamine (boiling point: 84°C), tripropanolamine (190°C), and triisopropanolamine (boiling point: 190°C) .

### (2) Type 2

Furthermore, in view of not lowering heat resistance and the like, a benzylamine having an aromatic ring could also be suitably used. Therefore, examples thereof include N,N-dimethylbenzylamine (boiling point: 180°C), phenylamine (= aniline, boiling point: 180°C), diphenylamine (boiling point: 302°C), triphenylamine (boiling point: 347°C), and N,N-dimethylaniline (boiling point: 194°C). Other examples include N,N-dimethyl-p-toluidine (boiling point: 211°C), 2-aminopyridine (boiling point: 204°C), 4-aminopyridine (boiling point: 273°C), 4-dimethylaminopyridine, tetrahydro-1,4-oxazidine (= morpholine, boiling point: 129°C), pyridine (boiling point: 115°C), hexahydropyridine (= piperidine, boiling point: 106°C), and pyrrolidine (boiling point: 87°C). Particularly, morpholine could be suitably, since morpholine does not deteriorate heat resistance and the like and does not easily cause discoloration when heat-treated.

### (3) Type 3

Moreover, a diamine compound having two amino groups in the molecular structure is also acceptable. The diamine compound may be either an aromatic compound or an aliphatic compound; however, an aromatic compound is desirable. Therefore, regarding such a diamine compound, for example, aromatic diamines such as p-phenylenediamine, m-phenylenediamine, 4,4'-diaminodiphenylmethane, 4,4'-diaminodiphenylethane, 4,4'-diaminodiphenyl ether, 4,4'-diaminodiphenyl sulfide, 4,4'-diaminodiphenylsulfone, 1,5-diaminonaphthalene, 3,3-dimethyl-4,4'-diaminobiphenyl, 5-amino-1-(4'-aminophenyl)-1,3,3-trimethylindane, 6-amino-1-(4'-aminophenyl)-1,3,3-trimethylindane, 4,4'-diaminobenzanilide, 3,5-diamino-3'-trifluoromethylbenzanilide, 3,5-diamino-4'-trifluoromethylbenzanilide, 3,4'-diaminodiphenyl ether, 2,7-diaminofluorene, 2,2-bis(4-aminophenyl)hexafluoropropane, 4,4'-methylene-bis(2-chloroaniline), 2,2',5,5'-tetrachloro-4,4'-diaminobiphenyl, 2,2'-dichloro-4,4'-diamino-5,5'-dimethoxybiphenyl, 3,3'-dimethoxy-4,4'-diaminobiphenyl, 4,4'-diamino-2,2'-bis(trifluoromethyl)biphenyl, 2,2-bis[4-(4-aminophenoxy)phenyl]propane, 2,2-bis[4-(4-aminophenoxy)phenyl]hexafluoropropane, 1,4-bis(4-aminophenoxy)benzene, 4,4'-bis(4-aminophenoxy)-biphenyl, 1,3'-bis(4-aminophenoxy)benzene, 9,9-bis(4-aminophenyl)fluorene, 4,4'-(p-phenyleneisopropylidene)bisaniline, 4,4'-(m-phenyleneisopropylidene)bisaniline, 2,2'-bis[4-(4-amino-2-trifluoromethylphenoxy)phenyl]hexafluoropropane, and 4,4'-bis[4-(4-amino-2-trifluoromethyl)phenoxy]-octafluorobiphenyl are preferred.

### (4) Type 4

Furthermore, an aromatic diamine having two amino groups bonded to an aromatic ring and a heteroatom other than the nitrogen atoms of the amino groups, such as diaminotetraphenylthiophene, is also preferred. Moreover, aliphatic diamines and alicyclic diamines, such as 1,1-methaxylylenediamine, 1,3-propanediamine, teramethylenediamine, pentamethylenediamine, octamethylenediamine, nonamethylenediamine, 4,4-diaminoheptamethylenediamine, 1,4-diaminocyclohexane, isophoronediamine, tetrahydrodicyclopentadienylenediamine, hexahydro-4,7-methanoindanylenedimethylenediamine, tricyclo[6,2,1,02.7]-undecylenedimethyldiamine, and 4,4'-methylenebis(cyclohexylamine) may be suitably mentioned.

### (5) Type 5

Anyways, it is preferable that the type of the amine compound is determined in consideration of the use or purpose of the aqueous treatment agent to be mixed with, or any fouling odor or the like. For example, in a case in which the ratio of the incorporation amount of the imide group-containing compound/incorporation amount of the fluororesin is relatively high, for example, in a case in which such a ratio is 1 to 10, reaction occurs sufficiently even under relatively low temperature heating conditions. Therefore, it is preferable that the amine compound is an amine compound having a relatively low boiling point, for example, having a boiling point of 150°C or lower. On the other hand, in a case in which the ratio of the incorporation amount of the imide group-containing compound/incorporation amount of the fluororesin is relatively low, for example, in a case in which such a ratio is 0.1 to below 1, since it is necessary to heat the fluororesin under relatively high temperature heating conditions, it is preferable to use an amine compound having a relatively high boiling point, for example, a boiling point of above 150°C.

### (6) Boiling point

It is preferable that the boiling point (under atmospheric pressure) of the amine compound has a value within the range of 50°C to 350°C. The reason for this is that when the boiling point of the amine compound is below 50°C, the amine compound could easily evaporate even at room temperature, and handleability may become poor, or there may be a problem with environmental safety. On the other hand, it is because when the boiling point of the amine compound is above 350°C, even in the case of being heat-treated, the amine compound is likely to remain in the surface treatment film and may deteriorate adhesiveness or mechanical strength. Therefore, it is more preferably that the boiling point of the amine compound is adjusted to a value within the range of 60°C to 300°C, and still more preferably to a value within the range of 70°C to 200°C.

### (7) Incorporation amount

It is preferable that the incorporation amount of the amine compound is adjusted to a value within the range of 0.1 to 30 parts by weight, in terms of solid content, with respect to 100 parts by weight of the imide group-containing compound included in the imide group-containing compound. The reason for this is that when the incorporation amount of such an amine compound is below 0.1 parts by weight, the effect of adding the amine compound to the aqueous treatment agent may not be exhibited, and satisfactory aqueous solution stability may not be obtained between the imide group-containing compound and the fluororesin-containing aqueous dispersion liquid. On the other hand, when the incorporation amount of such an amine compound is above 30 parts by weight, corrosiveness or residual properties may be enhanced, foul odor may become severe, or the aqueous treatment agent may be easily discolored in brown with the passage of time. Therefore, it is more preferably that the incorporation amount of the amine compound is adjusted to a value within the range of 1 to 20 parts by weight, and more preferably to a value within the range of 3 to 10 parts by weight, in terms of solid content, with respect to 100 parts by weight of the imide group-containing compound included in the imide group-containing compound.

### 4. Viscosity stabilizer

### (1) Type

The imide group-containing compound includes unavoidable metal ions, and thus, the imide group-containing compound may be in a pseudo-crosslinked state caused by predetermined carboxyl groups or hydroxyl groups. In such a case, a predetermined viscosity stabilizer may be added, or before being brought into a pseudo-crosslinked state, it is preferable to add at least one of an ortho-formic acid ester compound (trimethyl ortho-formate, triethyl ortho-formate, or the like), a phytic acid compound, a Dacrotized compound, or EDTA, in order to prevent the process. Therefore, when a predetermined viscosity stabilizer is incorporated, the viscosity stabilizer can capture and chelate the metal ions that are speculated to cause pseudo-crosslinking induced by carboxyl groups or hydroxyl groups, and can convert the imide group-containing compound that has come to a pseudo-crosslinked state and precludes viscosity measurement, into a compound having low viscosity (100 to 100,000 mPa · sec, measurement temperature 20°C), and into a state of being easily filterable or easily applicable.

### (2) Incorporation amount

Therefore, it is preferable that the incorporation amount of the predetermined viscosity stabilizer is adjusted to a value within the range of 0.01 to 10 parts by weight, more preferably to a value within the range of 0.1 to 7 parts by weight, and still more preferably to a value within the range of 0.5 to 5 parts by weight, per 100 parts by weight of the imide group-containing compound (before pseudo-crosslinked state).

### 5. Solvent

### (1) Type 1

Regarding the type of the solvent of the aqueous treatment agent (also including the dispersion liquid), it is preferable to use basically water, or water including 0.1% to 10% by weight of an amine compound. The reason for this is that when the solvent is water as such, in a case in which the aqueous treatment agent is applied and then heated to a temperature of at least 100°C or higher, or to a temperature of 150°C or higher, the solvent is scattered readily and rapidly, and the solvent could be effectively prevented from remaining in the surface treatment film.

### (2) Type 2

On the other hand, depending on the usage of the aqueous treatment agent, it is also preferable to incorporate a predetermined amount of an organic solvent. Such an organic solvent may be, for example, at least one of N-methyl-2-pyrrolidone (NMP), N,N-dimethylformamide, N,N-dimethylacetamide, methyl diglyme, methyl triglyme, dioxane, tetrahydrofuran, cyclohexanone, cyclopentanone, γ-butyrolactone, toluene, ethyl acetate, butyl acetate, cellosolve, methyl ethyl ketone (MEK), or anisole.

Particularly, a mixture of N-methylpyrrolidone and at least one of methanol, isopanol, butanol, ethyl acetate, butyl acetate, propylene glycol monomethyl ether, toluene, xylene, methyl ethyl ketone, cyclohexanone, dimethylacetamide, N,N-dimethylformamide, or water (weight ratio of NMP/another solvent = 80/20 or the like) is used, the imide group-containing compound could be impregnated uniformly and firmly without swelling the resin coating of enamel wire used for motor coils, and therefore, the mixture is a satisfactory solvent.

### (3) Incorporation amount

Furthermore, with regard to the incorporation amount of the solvent (mainly water) of the aqueous treatment agent, it is preferable to adjust the incorporation amount of the solvent to a value within the range of 40% to 99% by weight with respect to the total amount (100% by weight) thereof. The reason for this is that when the incorporation amount of such a solvent is adjusted to a predetermined range, handling is made easier. Furthermore, it is because application and drying are facilitated, and other components to be incorporated, for example, a thermoplastic resin component, a thermosetting resin component, a photocurable resin component, a metal material, and a ceramic material could be incorporated uniformly and rapidly.

More specifically, it is because when the incorporation amount of such a solvent has a value of below 40% by weight, the solubility of the imide group-containing compound or dispersibility of the fluororesin becomes insufficient, and handleabiility may be noticeably deteriorated. On the other hand, it is because when the incorporation amount of such a solvent has a value of above 99% by weight, the viscosity is excessively decreased, it may become difficult to form a uniform surface treatment film having a predetermined film thickness, or a precipitate may be easily produced. Therefore, it is more preferably to adjust the incorporation amount of the solvent to a value within the range of 50% to 90% by weight, and still more preferably to a value within the range of 60% to 80% by weight, with respect to the total amount of the aqueous treatment agent.

### 6. Viscosity of aqueous treatment agent

Furthermore, it is preferable that the viscosity of the aqueous treatment agent is adjusted usually to a value within the range of 10 to 50,000 mPa·sec (measurement temperature: 25°C, solid content concentration: 20% to 60% by weight; hereinafter, the same). The reason for this is that when the viscosity of the aqueous treatment agent is limited to a predetermined range, handling is made easier, and also, satisfactory storage stability is obtained. Furthermore, it is because applicability is enhanced, and other components to be incorporated, for example, a thermoplastic resin component, a thermosetting resin component, a photocurable resin component, a metal material, and a ceramic material could be incorporated uniformly and rapidly. Therefore, it is more preferably to adjust the viscosity of the aqueous treatment agent to a value within the range of 50 to 10,000 mPa·sec, and still more preferably to a value within the range of 100 to 5,000 mPa·sec.

### 7. Additives

Furthermore, in order to enhance stability of the aqueous solution, to enhance the dispersibility of the imide group-containing compound, to enhance the wettability toward a material to be treated where the aqueous treatment agent is applied, or to regulate the surface smoothness of the coating film thus obtainable, it is preferable to incorporate a predetermined surfactant, which is different from the viscosity stabilizer mentioned above, into the aqueous treatment agent. Furthermore, in the case of incorporating a surfactant, it is preferable that the incorporation amount thereof is adjusted usually to a value within the range of 0.005% to 10% by weight with respect to the total amount (100% by weight) of the aqueous treatment agent. The reason for this is that when the incorporation amount of such a surfactant has a value of below 0.005% by weight, the effect of addition may not be exhibited, and it is also because when the incorporation of such a surfactant is above 10% by weight, heat resistance or mechanical strength of the polyimide resin film thus obtainable may be decreased. Therefore, although the incorporation amount may vary depending on the type of the surfactant, it is more preferably that the incorporation amount is adjusted to a value within the range of 0.01% to 5% by weight, and still more preferably to a value within the range of 0.05% to 1% by weight, with respect to the total amount of the aqueous treatment agent.

Furthermore, it is also preferable to incorporate a least one known additive such as an inorganic filler, an organic filler, an inorganic fiber, an organic fiber, an electrically conductive material, an electrically insulating material, a metal ion scavenger, a weight reducing agent, a thickener, a filler, a polishing agent, a colorant material, an oxidation inhibitor, a hydrolysis inhibitor, an ultraviolet absorber, or the like. Further, in a case in which at least one of these known additives is incorporated, it is preferable that the incorporation amount of the additive is adjusted usually to a value within the range of 0.1% to 50% by weight, more preferably to a value within the range of 0.5% to 30% by weight, and still more preferably to a value within the range of 1% to 10% by weight, with respect to the total amount (100% by weight) of the aqueous treatment agent.

### 8. Low-temperature curability and use

### (1) Primary heating

Furthermore, with regard to the low-temperature curability of the aqueous treatment agent, for example, there is a feature that when the aqueous treatment agent is subjected to primary heating under heating conditions of 120°C for 60 minutes and cured, a predetermined resin (the main component is a polyamideimide resin) for which the 10% weight reduction temperature measured with a thermobalance according to JIS K 7120 has a value of 200°C or higher. That is, it is because when the aqueous treatment agent is subjected to primary heating under such low temperature conditions, the imide group-containing compound included in the aqueous treatment agent becomes a polyamideimide resin having a predetermined structure, the 10% weight reduction temperature is above 200°C, and high heat resistance and mechanical strength are obtained. Then, since the imide group-containing compound and the fluorine-based resin undergo phase separation in a critical way mainly during primary heating, it can be said that after secondary heating that will be described below, more satisfactory adhesiveness and the like could be exhibited toward various resin molded articles, metals, and the like, including polyimide resin molded articles and fluororesin molded articles.

### (2) Secondary heating

Furthermore, after the aqueous treatment agent is laminated on an object to be treated, it is preferable that secondary heating (additional heating) is performed usually under heating conditions of 200°C and 60 minutes or longer. That is, it is preferable that the aqueous treatment agent is subjected to primary heating at 120°C for 60 minutes, and then to secondary heating at 200°C for 60 minutes (this may be referred to as step curing). The reason for this is that a surface treatment film for which the 10% weight reduction temperature measured with a thermobalance according to JIS K 7120 has a value of 250°C or higher can be obtained. Therefore, as a polyimide resin having a predetermined structure is formed by step curing as such additional heating, and the fluororesin is sufficiently dissolved and becomes crystalline, the 10% weight reduction temperature reaches above 250°C, and superior heat resistance and mechanical strength could be obtained.

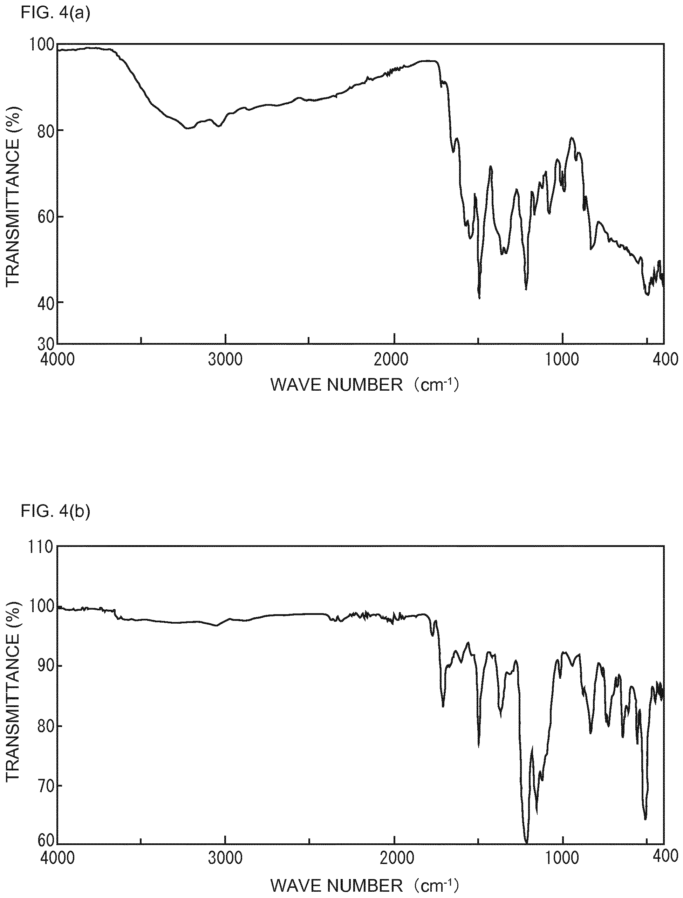

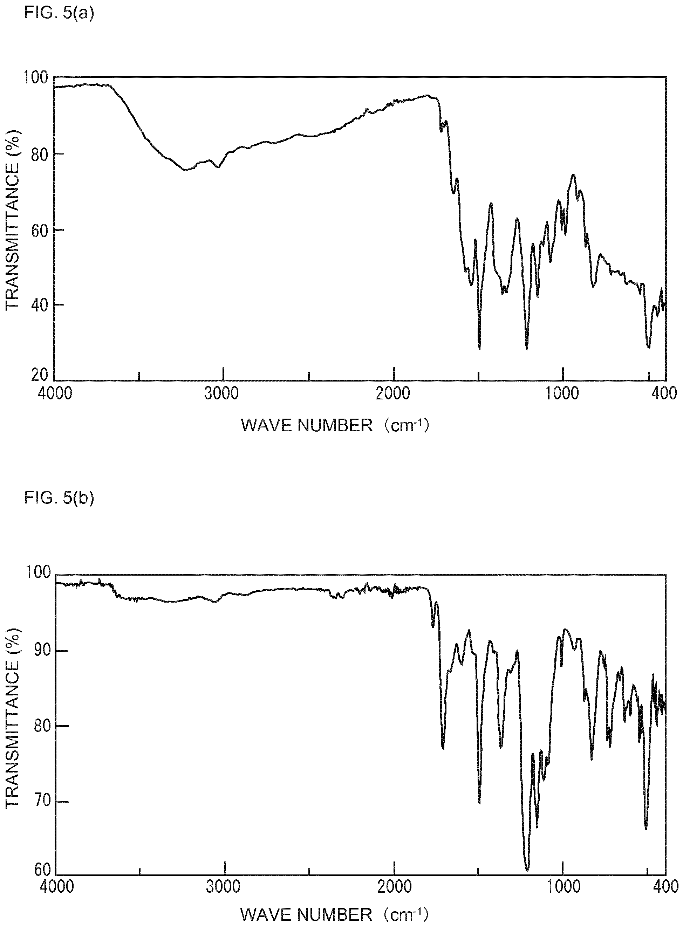

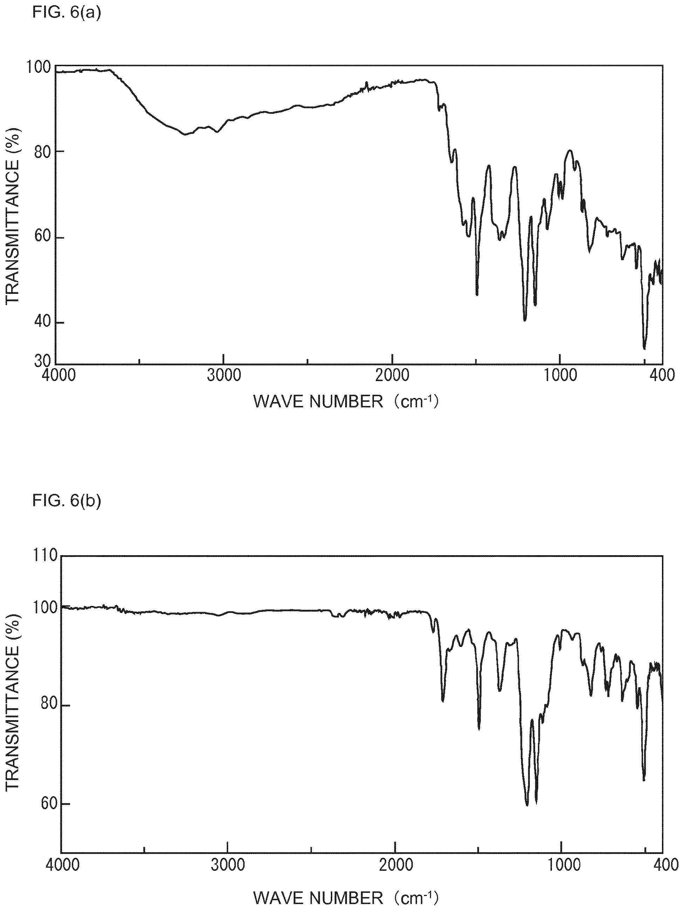

Here, Figs. 4(a) and 4(b) are FT-IR charts obtained before curing (natural drying for 60 minutes) and after curing (natural drying for 60 minutes + curing at an increased temperature of 60°C to 360°C, total 100 minutes), respectively, of an aqueous treatment agent (PI resin: 100%) (1 of those charts). Furthermore, Figs. 5(a) and 5(b) are FT-IR charts obtained before curing (natural drying for 60 minutes) and after curing (natural drying for 60 minutes + curing at an increased temperature of 60°C to 360°C, total 100 minutes), respectively, of an aqueous treatment agent (imide group-containing compound/fluororesin: 9/1) (2 of those charts). Figs. 6(a) and 6(b) are FT-IR charts obtained before curing (natural drying for 60 minutes) and after curing (natural drying for 60 minutes + curing at an increased temperature of 60°C to 360°C, total 100 minutes), respectively, of an aqueous treatment agent (imide group-containing compound/fluororesin: 7/3) (3 of those charts).

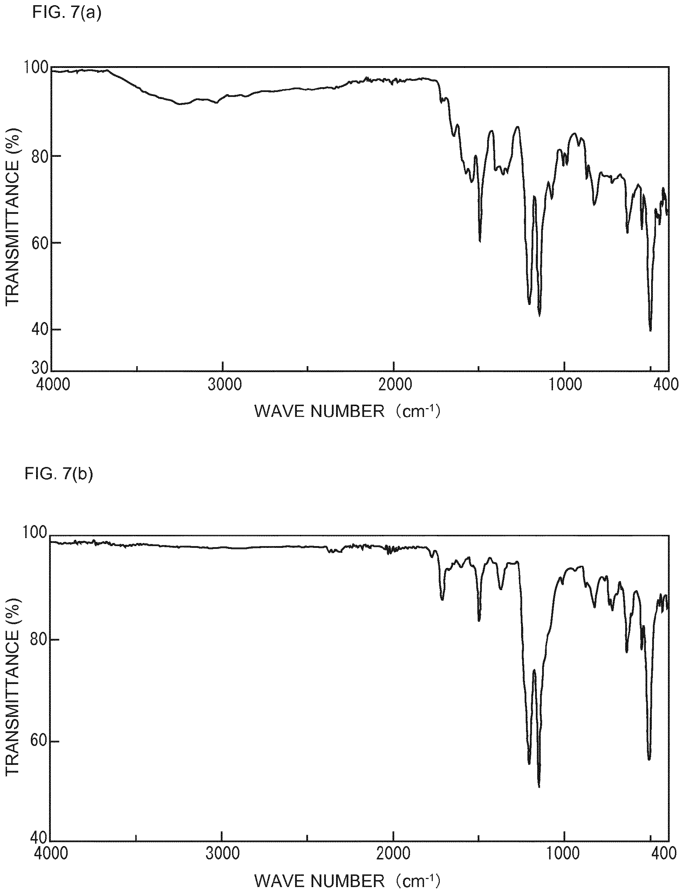

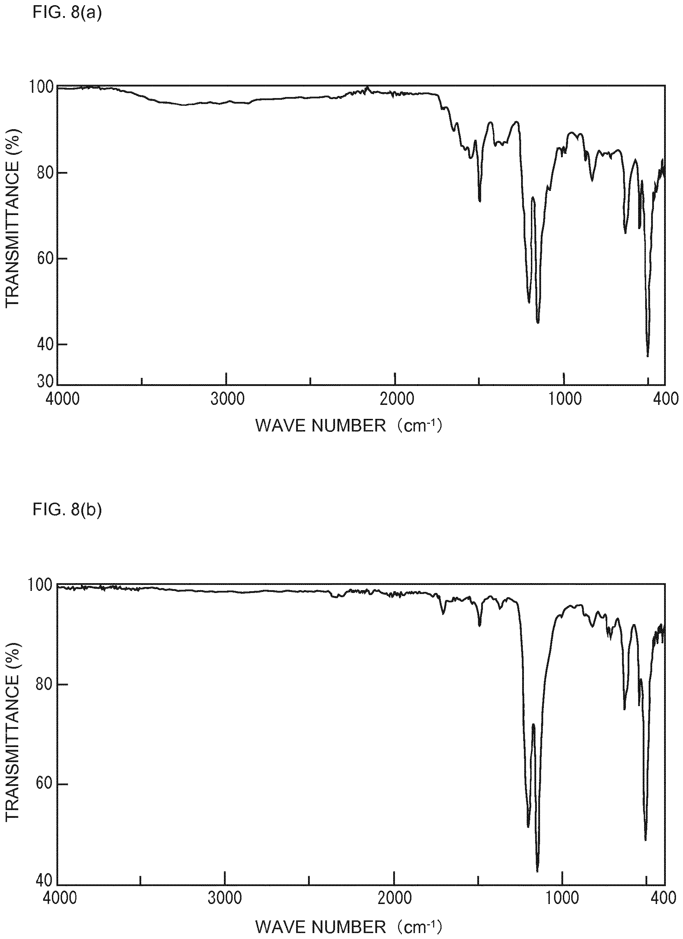

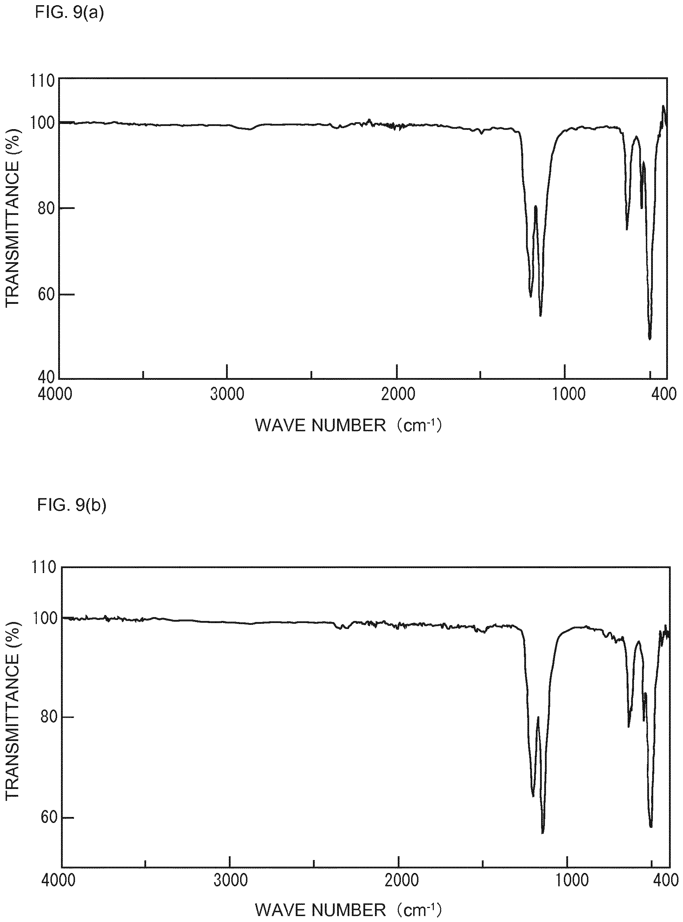

Figs. 7(a) and 7(b) are FT-IR charts obtained before curing (natural drying for 60 minutes) and after curing (natural drying for 60 minutes + curing at an increased temperature of 60°C to 360°C, total 100 minutes), respectively, of an aqueous treatment agent (imide group-containing compound/fluororesin: 5/5) (4 of those charts). Figs. 8(a) and 8(b) are FT-IR charts obtained before curing (natural drying for 60 minutes) and after curing (natural drying for 60 minutes + curing at an increased temperature of 60°C to 360°C, total 100 minutes), respectively, of an aqueous treatment agent (imide group-containing compound/fluororesin: 5/5) (5 of those charts). Furthermore, Figs. 9(a) and 9(b) are FT-IR charts obtained before curing (natural drying for 60 minutes) and after curing (natural drying for 60 minutes + curing at an increased temperature of 60°C to 360°C, total 100 minutes), respectively, of an aqueous treatment agent (fluororesin: 100%) (6 of those charts).

Therefore, it is understood from these FT-IR charts obtained before and after heat treatments that with regard to the imide group-containing compound, a curing reaction proceeds by a heating treatment, and the heights of predetermined peaks (height of an absorption peak originating from a benzene ring at a wave number of 1,500 cm⁻¹: S1, height of an absorption peak originating from an imide group at a wave number of 1,375 cm⁻¹: S2, height of an absorption peak originating from an amide group at a wave number of 1,600 cm⁻¹: S3, height of an absorption peak originating from a carboxyl group at a wave number of 1,413 cm⁻¹: S4) are respectively changed. On the other hand, with regard to the fluororesin, the height of a predetermined peak is slightly changed by a heating treatment; however, when the change is compared with the change in the peak height for the imide group-containing compound, it is understood that the extent of the change is quite small.

### (3) Temperature increase and heating

Furthermore, there may be some parts similar to the step curing; however, for example, it is preferable that the temperature is increased, starting from room temperature, to a temperature of 200°C or higher, more preferably 250°C or higher, and still more preferably about 300°C to 380°C at a rate of temperature increase of 1°C/minute to 20°C/minute, and while the laminated aqueous treatment agent is heated, the imide group-containing compound as well as the fluororesin are also heat-treated. The reason for this is that in the case of step curing, first, the heating furnace is changed, the temperature is returned to a temperature near room temperature, and then secondary heating is performed in many cases; however, in the case of temperature increase and heating, there is a feature that temperature increase is continuously carried out up to a predetermined temperature without returning to a temperature near room temperature. Therefore, when temperature increase and heating is employed, the imide group-containing compound sufficiently reacts and is thermally cured to become a polyimide compound, while the fluororesin could be sufficiently dissolved and crystallized (depending on the case, amorphized). Thus, a glossy surface treatment film rich in transparency can be obtained.

Then, when the temperature increase and heating method is sued, the imide group-containing compound and the fluororesin included in the aqueous treatment agent undergo phase separation in a critical way and by utilizing an imide group-containing compound-rich layer in a surface treatment film thus formed, more satisfactory adhesiveness to various resin molded articles, metals, and the like could be exhibited. On the other hand, by utilizing a fluororesin-rich layer in the surface treatment film formed simultaneously with phase separation, satisfactory water repellency or peelability, or satisfactory adhesiveness to fluorine-based resins could be exhibited.

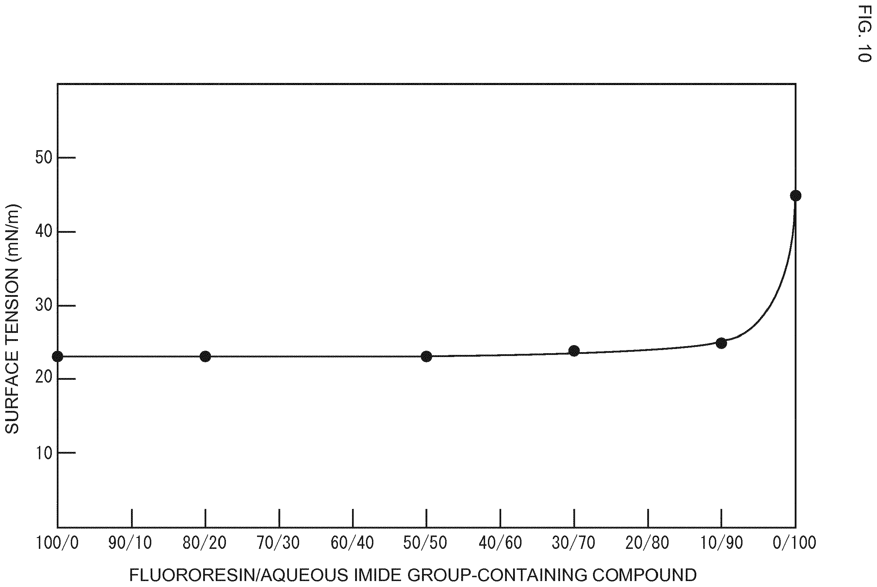

Here, the phase separation state in the surface treatment film will be described more specifically with reference to Fig. 10. That is, the transverse axis of Fig. 10 represents the mixing ratio (-) of the imide group-containing compound and the fluororesin included in the aqueous treatment agent, and the vertical axis represents the value of surface tension (mN/m) of the surface treatment film.

As shown by the characteristics curve described in Fig. 10, when the mixing ratio of the fluororesin/imide group-containing compound based on the solid content is in the range of about 90/10 to 10/90, the surface tension has a value close to 22 mN/m, which is the value of surface tension of the fluororesin as simple substance, in all cases, and no significant difference can be seen in this state. That is, as shown in Fig. 1(a) and the like, it is strongly presumed that when one of the surfaces of the surface treatment film 10 obtainable by phase separation is designated as front surface side, and the other surface is designated as rear surface side, a fluororesin-rich layer 10a is formed on the front surface side, while a polyimide resin-rich layer 10b, which is a cured product of the imide group-containing compound, is formed.

In contrast, as the mixing ratio of the fluororesin/imide group-containing compound based on the solid content exceeds 10/90, passes 5/95, and approximates 0/100, the value of the surface tension increases rapidly and reaches a value almost equal to 44 mN/m, which is the value of surface tension of the polyimide resin as simple substance. That is, it is strongly presumed that when such a mixing ratio exceeds 10/90 and approximates 0/100, basically the content of the polyimide resin is significantly large, and therefore, phase separation between the fluororesin and the polyimide resin hardly occurs, or phase separation occurs to some extent; however, since the existence amount of the polyimide resin is significantly large, the mixture exhibits the value of surface tension of the polyimide resin as simple substance.

### (4) Specific examples

The use applications of the aqueous treatment agent of the present invention are not particularly limited; however, for example, the aqueous treatment agent could also be used as an aqueous treatment agent for various resin films, resin molded articles, metal films, metal molded articles, ceramic films, ceramic molded articles, paper, or wood. That is, owing to the phase separation between the polyimide resin and the fluororesin included in the aqueous treatment agent, although there may be variations depending on the mixing ratio of the fluororesin/polyimide resin mixing ratio, the aqueous treatment agent can form a fluororesin-rich layer having water repellency, peelability, low dielectric constant, and the like on the front surface side of the surface treatment film, even with a relatively low mixing ratio of the fluororesin, while the aqueous treatment agent can form a polyimide resin-rich layer having excellent adhesiveness to various base materials, excellent heat resistance, mechanical characteristics, ultraviolet absorption properties, and the like. It is speculated that the boundary between the fluororesin-rich layer and the polyimide resin-rich layer is not clearly defined and is strongly bound.

Therefore, by utilizing such a fluororesin-rich layer of the surface treatment film, the surface treatment film is suitable for at least one of an aqueous treatment agent for heat resistance use, an aqueous treatment agent for water repellency use, an aqueous treatment agent for ultraviolet resistance use, an aqueous treatment agent for high dielectric constant use, an aqueous treatment agent for electrical insulation resistance use, an aqueous treatment agent for decorative agent use, and the like. Furthermore, by utilizing the polyimide resin-rich layer of the surface treatment film, the surface treatment film could be used as a raw material at the time of producing a polyimide film having satisfactory heat resistance or the like, a heat-resistant electrical component housing, a heat-resistant electronic component molded article, a heat-resistant circuit board, a heat-resistant container, a heat-resistant machine component, a heat-resistant automotive part, an ultraviolet-absorptive molded article, an ultraviolet-absorbing film, and the like.

Here, with reference to Figs. 1(a) to 1(d) again, configuration examples of a surface treatment film 10 originating from the aqueous treatment agent and a polyimide resin molded article formed using the surface treatment film (a surface treatment film 10, a polyimide film 10' for a single-sided high-frequency circuit, a polyimide film 10" for a double-sided high-frequency circuit, and a circuit board 14 for a single-sided high frequency use) will be specifically described. That is, the surface treatment film 10 illustrated in Fig. 1(a) shows that when the aqueous treatment agent of the present invention is applied on a peelable member or the like and then heat-treated at a predetermined temperature, phase separation occurs between the imide group-containing compound and the fluororesin, and a fluororesin-rich layer 10a and a polyimide resin-rich layer 10b are formed. Therefore, in fact, the surface treatment film 10 could be removed from the peelable member as a surface treatment film 10 having a two-layer structure, and the surface treatment film could be used for various use applications. Therefore, as viewed in the diagram, a surface treatment film 10 including a fluororesin-rich layer 10a having a low dielectric constant on the front surface side and including a polyimide resin-rich layer 10b having excellent heat resistance, mechanical strength, adhesiveness, ultraviolet resistance, and the like on the lower layer side could be obtained.

Fig. 1(b) illustrates, for example, a polyimide film 10' for a single-sided high-frequency circuit as a composite polyimide resin molded article, in which actually a surface treatment film 10 having a two-layer structure is formed on one surface of a polyimide film 10c. As such, when such a polyimide film 10' for a single-sided high-frequency circuit composed of a polyimide film 10c and a surface treatment film 10 is used, the surface tension is adjusted to a predetermined range, the polyimide film 10' can serve as a composite polyimide film laminate including a fluororesin-rich layer 10a having a low dielectric constant on the front surface side, and a predetermined metal conductor or the like could be firmly laminated thereon. Therefore, a substrate for electrical insulation (including a film for electrical insulation) such as a high-frequency circuit board having a low-dielectric constant or a heat-resistant circuit board could be constructed using the polyimide film 10' for a single-sided high-frequency circuit formed from the surface treatment film 10.

Fig. 1(c) illustrates an example of a polyimide film 10" for a double-sided high-frequency circuit, which is formed by applying the aqueous treatment agent on each of both surfaces of a polyimide film 10c, subsequently heat-treating the polyimide film at a predetermined temperature, and forming, on both surfaces, a first surface treatment film including a fluororesin-rich layer 10a and a polyimide resin-rich layer 10b and a second surface treatment film including a fluororesin-rich layer 10a' and a polyimide resin-rich layer 10b'. As such, a polyimide film 10" for a double-sided high-frequency circuit having low-dielectric constant fluororesin-rich layers 10a and 10a' on both surfaces of a polyimide film 10c could be obtained. Therefore, when a conductor layer is formed on each of those first surface treatment film and second surface treatment film, and then a predetermined circuit is formed by photolithography or the like, a double-sided high-frequency circuit board having a low dielectric constant, a double-sided heat-resistant circuit board, or the like could be constructed.

Fig. 1(d) illustrates a single-sided high-frequency circuit board obtained by applying the aqueous treatment agent of the present invention as a primer treatment on one side of a polyimide film 10c, further heat-treating the polyimide film at a predetermined temperature, thereby forming a surface treatment film 10 including a fluororesin-rich layer 10a and a polyimide resin-rich layer 10b, and including a predetermined functional film (metal layer) 12 and a separate primer layer 12a thereon. As such, by including a surface treatment film 10 as a primer layer on one surface of a polyimide film 10c, strong adhesive force could be obtained between the polyimide film 10c and the separate primer layer 12a and the predetermined functional film (metal layer) 12, which are formed above the surface treatment film 10. Therefore, according to the use application, for example, a metal layer, an electroconductive film, an antistatic-treated film, an electrically insulating film, a gas barrier film, a mold release layer (fluororesin layer), and a decorative layer could be each formed firmly as the predetermined functional film 12.

In addition to that, the aqueous treatment agent of the present invention has a feature of exhibiting excellent ultraviolet absorption properties even in a case in which an ultraviolet absorber or the like is not further incorporated. Therefore, for example, it has been found that even a thin film coating film having a thickness of about 8 to 20 µm could cut off 99% or more, and more preferably 99.9% or more, of ultraviolet radiation having a wavelength of 300 to 400 nm. That is, since the aqueous treatment agent of the present invention and an ultraviolet absorbing layer thus obtainable have extremely excellent ultraviolet absorption properties and weather resistance even as thin films, the ultraviolet absorbing layer could be suitably used as an ultraviolet absorbing film including a peelable member, an adhesive, a polyester base material, and an ultraviolet absorbing layer formed from the aqueous treatment agent of the present invention.

### [Second embodiment]

A second embodiment is a method for producing an aqueous treatment agent including an imide group-containing compound obtained by partially hydrolyzing a polyimide molded article, a fluororesin-containing aqueous dispersion liquid, and an amine compound, the method including the following steps (1) to (3):
(1) a step of preparing a solution of an imide group-containing compound, as a first solution, by incorporating an aqueous solvent in an amount having a value within the range of 0.1 to 30 parts by weight, in terms of solid content, with respect to 100 parts by weight of the imide group-containing compound, and incorporating an amine compound in an amount having a value within the range of 0.1 to 30 parts by weight with respect to 100 parts by weight of the imide group-containing compound;
(2) a step of preparing a fluororesin-containing aqueous dispersion liquid as a second solution; and
(3) a step of mixing the first solution and the second solution such that the incorporation amount of the fluororesin included in the second solution is adjusted to a value within the range of 0.1 to 10,000 parts by weight, in terms of solid content, with respect to 100 parts by weight of the imide group-containing compound included in the first solution, and thus obtaining an aqueous treatment agent.

In the following description, the method for producing an aqueous treatment agent as the second embodiment will be described in sequence according to steps (1) to (3).

### 1. Step (1)

Step (1) includes a preparation process of cutting a polyimide molded article into a predetermined size. Therefore, it is preferable that a polyimide molded article as an industrial waste is cut or classified using a cutting apparatus, a pulverization apparatus, a classification apparatus, or the like, and the maximum width or the average particle size of the resultant is adjusted in advance. That is, it is preferable that a polyimide molded article as an industrial waste or the like is cut or classified using a cutter, a knife, a chopper, a shredder, a ball mill, a pulverization apparatus, a sieve, a punching metal, a cyclone or the like, and the maximum width or average particle size of the resultant is adjusted in advance, so that partial hydrolysis could be achieved more uniformly and rapidly.

More specifically, in the case of adjusting a polyimide molded article into a short strip form, it is preferable that the average width of the short strip is adjusted to a value of 10 mm or less, and more preferably to a value within the range of 1 to 5 mm. Furthermore, in the case of adjusting the polyimide molded article into a particulate form, it is preferable that the average particle size of the particles is adjusted to a value of 10 mm or less, and more preferably to a value within the range of 1 to 5 mm. Furthermore, in order to make the maximum width or the average particle size even, it is preferable that the short strips or particles are introduced into a resin pulverizing machine including a punching metal, a sieve, or the like, the short strips or particles are pulverized while being cooled using dry ice or the like, and thus a polyimide pulverization product in the form of small chips or particles is obtained.

Next comes a process of partially hydrolyzing the polyimide molded article having a predetermined size in the presence of at least water and a basic compound under temperature conditions of 40°C to 100°C, and more preferably under temperature conditions of 50°C to 80°C, and obtaining a crude imide group-containing compound. Therefore, it is preferable that the polyimide molded article is hydrolyzed in the presence of at least water and a basic compound at a predetermined temperature, for example, under the conditions of normal pressure for 1 to 48 hours. Here, the basic compound means a compound that generates hydroxide ions, and examples thereof include sodium hydroxide, calcium hydroxide, and sodium hydrogen carbonate.

As mentioned above, whether a polyimide molded article has been partially hydrolyzed and a desired crude imide group-containing compound has been obtained can be checked by checking the presence or absence of an absorption peak originating from an imide group, an absorption peak originating from an amide group, an absorption peak originating from a carboxyl group, or the like in an infrared spectroscopic spectral chart obtainable in the case of performing an infrared spectroscopic analysis, or checking that the respective peak heights of the absorption peaks, the height ratios relative to an absorption peak originating from a benzene ring, and the like have values within predetermined ranges.

Next comes a process of purifying the crude imide group-containing compound, and obtaining an imide group-containing compound having an absorption peak originating from an imide group at a wave number of 1,375 cm⁻¹, an absorption peak originating from an amide group at a wave number of 1,600 cm⁻¹, and an absorption peak originating from a carboxyl group at a wave number of 1,413 cm⁻¹ in an infrared spectroscopic spectral chart obtainable in the case of performing an infrared spectroscopic analysis. Therefore, it is preferable that after an imide group-containing compound having predetermined absorption peaks is obtained, the compound is neutralized by performing an acid treatment (treating with hydrochloric acid, nitric acid, sulfuric acid, phosphoric acid, an organic acid, or the like), the neutralization product is further subjected to a water washing process, for example, repeatedly for five times, thereby the crude imide group-containing compound is purified, and thus an imide group-containing compound (particulate form) having impurities removed therefrom is obtained.

Then, in order to effectively avoid the influence of an acid component or an alkali component remaining in the crude imide group-containing compound, for example, the influence on heat resistance, metal corrosion, or the like, it is more preferably to use phosphoric acid, which is a weak acid, for the acid treatment, and it is more preferably to use potassium hydroxide as the alkali treatment. Furthermore, after the crude imide group-containing compound is purified and dried, in order to make the particle size even, it is preferable to classify the imide group-containing compound into predetermined particle sizes using sieves.

In addition, whether the crude imide group-containing compound has been sufficiently purified could be verified by quantitatively determining that elements (or element ions) such as chlorine, sulfur, phosphorus, aluminum, and magnesium are present in predetermined amounts or less, using ion chromatography or X-ray photoelectron spectroscopy (XPS). More specifically, for example, it is quantitatively determined by ion chromatographic element analysis that the content of chlorine ion is 100 ppm or less, more preferably 10 ppm or less, and still more preferably 1 ppm or less, and thus the extent of purification of the crude imide group-containing compound can be checked.

Lastly, the imide group-containing compound obtained in the previous process is dissolved in a predetermined amount of an aqueous solvent, and thereby an imide group-containing compound solution is obtained. At this time, as the aqueous solution, NMP is used alone in a small amount at first, and at least one of known stirring apparatuses is used, and thus a uniform solution (master batch) is obtained. Subsequently, the aqueous solvent is incorporated as a diluent, and thereby an imide group-containing compound solution could be produced in a very short time. Therefore, this is practical as a method for producing an imide group-containing compound solution.

On the other hand, it has been found that when an aqueous solution obtained by incorporating a predetermined amine compound into the aqueous solvent is used, since the imide group-containing compound dissolves easily, an imide group-containing compound solution could be produced in a short time. Anyways, it is suitable to incorporate a predetermined amount of phytic acid, triethyl ortho-formate, or the like as a viscosity stabilizer in the stage of having produced the imide group-containing compound solution, or in the middle of the stage.

### 2. Step (2)

Step (2) is a step of preparing a fluororesin-containing aqueous dispersion liquid. That is, it is a step of preparing a fluororesin-containing aqueous dispersion liquid by incorporating particles (average particle size: 0.01 to 10 µm) of a fluororesin having a solid content of 30% to 70% by weight into water directly or together with a surfactant, and uniformly mixing the mixture. Meanwhile, as long as the average particle size and the like of the fluororesin particles are within predetermined ranges, it is also possible to use a commercially available fluororesin-containing aqueous dispersion liquid.

### 3. Step (3)

Step (3) is a step of mixing the imide group-containing compound solution obtained in step (1) and the fluororesin-containing aqueous dispersion liquid obtained in step (2), and obtaining an aqueous treatment agent. That is, it is a step of preparing an aqueous treatment agent by adjusting the incorporation amount of a fluororesin included in the fluororesin-containing aqueous dispersion liquid to a value within the range of 0.1 to 10,000 parts by weight, in terms of solid content, with respect to 100 parts by weight of the imide group-containing compound. More specifically, the mixture is mildly stirred until the mixture becomes uniform, using at least one of known stirring apparatuses such as a propeller mixer, a planetary mixer, a ball mill, a jet mill, a vibratory mill, and a three-roll, and thus an aqueous treatment agent including an imide group-containing compound, a fluororesin, and the like could be obtained.

### 4. Other inspection processes

It is preferable that an inspection process of inspecting the solid content, viscosity, external appearance, reactivity, and the like of the aqueous treatment agent thus obtained is provided to check whether those properties have values within predetermined ranges.

### [Third embodiment]

A third embodiment is a surface treatment method of using an aqueous treatment agent including an imide group-containing compound obtained by partially hydrolyzing a polyimide molded article, and a fluororesin-containing aqueous dispersion liquid, the method including the following steps (1') to (3'):
(1') a step of preparing an aqueous treatment agent including an imide group-containing compound obtained by partially hydrolyzing a polyimide molded article, a fluororesin-containing aqueous dispersion liquid, and an amine compound, by adjusting the incorporation amount of a fluororesin included in the fluororesin-containing aqueous dispersion liquid to a value within the range of 0.1 to 10,000 parts by weight, in terms of solid content, with respect to 100 parts by weight of the imide group-containing compound, and adjusting the incorporation amount of the amine compound to a value within the range of 0.1 to 30 parts by weight with respect to 100 parts by weight of the imide group-containing compound;
(2') a step of laminating the aqueous treatment agent on the surface of a material to be treated; and
(3') a step of heating the aqueous treatment agent laminated on the surface of the material to be treated to a temperature of 200°C or higher, and thereby obtaining a surface treatment film.

In the following description, with reference to Figs. 10(a) to 10(d), the method of using an aqueous treatment agent of the third embodiment will be described in sequence according to steps (1') to (3').

### 1. Step (1')

Step (1') is a step for preparing an aqueous treatment agent, and since the matters are substantially the same as the matters of the method for producing an aqueous treatment agent of embodiment 2 described above, further explanation will not be repeated here.

### 2. Step (2')

Step (2') is a step of laminating the aqueous treatment agent obtained in step (1') on the surface of a material to be treated 50. Here, representative examples of the material to be treated 50 include a polyimide-based resin molded article (film), a fluorine-based resin molded article (film), and a metal (iron, aluminum, or the like). That is, a polyimide-based resin molded article may usually have slightly weak chemical resistance (alkali resistance), too high adhesiveness, low anti-fouling properties, and slightly high dielectric loss. Therefore, in such a case, when the aqueous treatment agent thus obtained is applied on a polyimide-based resin molded article or an iron base material and then treated by heating, a surface treatment film that has strong chemical resistance (alkali resistance) and could regulate adhesiveness, dielectric characteristics could be formed on the surface of the polyimide-based resin molded article or the iron base material.

Furthermore, a fluorine-based resin molded article may usually have weak mechanical strength, too high surface water repellency, and low adhesiveness of the surface. Therefore, in such a case, when the aqueous treatment agent thus obtained is applied on the surface of the fluorine-based resin molded article and then treated by heating, a surface adjustment layer that has strong mechanical strength and could regulate adhesiveness, dielectric characteristics, and the like could be formed on the surface of the fluorine-based resin molded article. Furthermore, a polyester-based resin molded article may usually have insufficient mechanical strength, heat resistance, or ultraviolet resistant characteristics, and low adhesiveness. Therefore, since the aqueous treatment agent thus obtained is applied on the surface of a polyester-based resin molded article and then treated by heating, the aqueous treatment agent enhances the mechanical strength, heat resistance, or ultraviolet resistant characteristics of the polyester-based resin molded article, and excellent adhesiveness, dielectric characteristics, and the like could be obtained.

Therefore, there are no particular limitations on the various materials to be treated, to which the aqueous treatment agent thus obtained is applied; however, for example, the aqueous treatment agent could be suitably applied to not only the above-mentioned resin molded articles but also other various resin molded articles (films), metal films, metal molded articles, ceramic films, ceramic molded articles (also including glass molded articles), paper, wood, and the like, and could exhibit desired surface treatment characteristics. It is preferable that the thickness of the material to be treated 50 is usually adjusted to a value within the range of 50 to 5,000 µm, more preferably to a value within the range of 100 to 2,000 µm, and still more preferably to a value within the range of 200 to 1,000 µm.

### 5. Step (3')

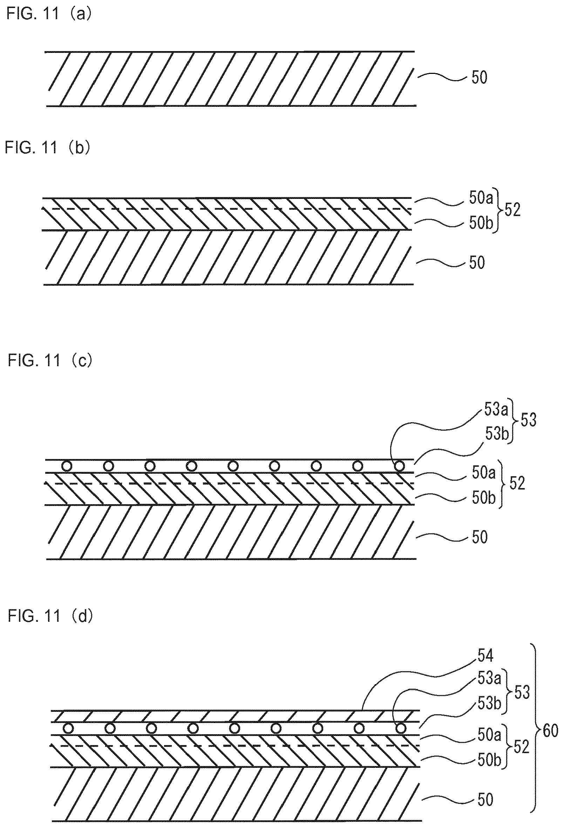

Next, step (3') is a step of laminating, as illustrated in Fig. 11(b), the aqueous treatment agent on the surface of the material to be treated 50, subsequently leaving the laminate to stand at room temperature for 1 to 24 hours, further heat-treating the laminate at a temperature of 200°C or higher, and thereby obtaining a predetermined surface treatment film 52. That is, it is a step of scattering the moisture and amine compound included in the aqueous treatment agent by performing a heating treatment as such, and also, basically causing phase separation of the imide group-containing compound and the fluororesin to actually produce a surface treatment film 52 having a two-layer structure. Furthermore, it is also because when a heating treatment is carried out as such, the fluororesin included in the aqueous treatment agent is dissolved and crystallized to produce a uniform surface, and also, surface water repellency or peelability is enhanced.

As described in the first embodiment, secondary heating may be carried out, and it is also preferable that a temperature increase and heating treatment is carried out to 200°C or higher, more preferably 250°C or higher, and still more preferably to 300°C or higher, at a rate of temperature increase of 1°C/minute to 20°C/minute. Regarding the thickness of the surface treatment film 52, it is preferable that the thickness is adjusted usually to a value within the range of 1 to 1,000 µm, more preferably to a value within the range of 10 to 500 µm, and still more preferably to a value within the range of 20 to 300 µm.

### 6. Additional step (4)

Next, additional step (4) is a step of forming a coloring layer 53, which is an optional layer, above the predetermined surface treatment film 52, as illustrated in Fig. 11(c). That is, it is preferable to carry out a process of forming a coloring layer 53 that includes a resin layer 53b for colorant material dispersion derived from a fluorine-based resin and containing white titanium oxide or the like as a colorant material 53a. When a coloring layer 53 is formed as such, there is an advantage that decorativeness is further enhanced, and in a case in which the surface treatment film is used for a frying pan, a hot plate, or the like, distinction between the coloring layer and cooked materials is so clear that cooking is made easier. It is preferable that the thickness of such a coloring layer 53 is adjusted usually to a value within the range of 1 to 100 µm, more preferably to a value within the range of 10 to 80 µm, and still more preferably to a value within the range of 20 to 60 µm. Meanwhile, in order to form the coloring layer 53 more firmly above a predetermined surface treatment film 52, it is preferable that the temperature employed at the time of forming the predetermined surface treatment film 52 is set in the range of 170°C to 200°C, and in a state in which the predetermined surface treatment film 52 is partially undried, the coloring layer 53 is formed by heat-treating the coloring layer in a temperature range of, for example, 300°C to 380°C.

### 7. Additional step (5)

Next, additional step (5) is a step of forming an overcoat layer 54 formed from a transparent fluorine-based resin or the like, above the predetermined coloring layer 53, as illustrated in Fig. 11(d). That is, it is a step of forming an overcoat layer 54 formed from a fluororesin having a relatively high molecular weight or a vitreous material (silica, a polysilazane film, diamond carbon, or the like) as a surface protective layer. As such, by forming an overcoat layer 54, decorativeness is further enhanced, and in a case in which the surface treatment film is used for a frying pan, a hot plate, or the like, mechanical protection and durability of the coloring layer 53 or the surface treatment film 52 are enhanced. It is preferable that the thickness of such an overcoat layer 54 is adjusted usually to a value within the range of 1 to 1,000 µm, more preferably to a value within the range of 10 to 500 µm, and still more preferably to a value within the range of 20 to 100 µm. In order to form an overcoat layer 54 more firmly above a predetermined surface treatment film 52 or above a coloring layer 53 and a surface treatment film 52, it is preferable that the temperature employed at the time of forming the predetermined surface treatment film 52, or the coloring layer 53 and the surface treatment film 52, is set in the range of 170°C to 200°C, and in a state in which the predetermined surface treatment film 52, or the coloring layer 53 and the surface treatment film 52 are partially undried, the overcoat layer 54 is formed by heat-treating the overcoat layer in a temperature range of, for example, 300°C to 380°C.

### 8. Others

It is preferable that the above-mentioned overcoat layer 54 is basically transparent (visible light transmittance is, for example, 90% or higher), and the coloring layer 53 as an undercoat is visually recognizable. However, in a case in which the coloring layer 53 as an undercoat has been omitted, or in order to enhance the mechanical strength, heat resistance, durability, and the like of the overcoat layer 54, it is also preferable that at least one inorganic filler such as aluminum oxide, silicon oxide (silica), zirconium oxide, titanium, titanium oxide, calcium carbonate, corundum, powdered glass, and the like is incorporated in a predetermined amount.

### EXAMPLES

Hereinafter, the present invention will be described in more detail by way of Examples.

### [Example 1]

### 1. Production of aqueous treatment agent

### (1) Step (1)

A KAPTON film (KAPTON 100H is a main material; however, mixture with other KAPTON films, manufactured by Du Pont-Toray Co., Ltd.) as a polyimide molded article was cut into a short strip form having a width of 10 mm or less, using a chopper. Next, while the cut film strips were cooled by adding dry ice, the cut film strips were introduced into a resin pulverizing machine (product No. P-1314, Horai Co., Ltd.) equipped with a punching metal having a diameter of 3 mm, and the polyimide molded article that passed through the punching metal (average particle size: about 3 mm) was used as a polyimide pulverization product as an object to be partially hydrolyzed.

Next, 5 g of the polyimide pulverization product thus obtained, 400 g of ion-exchanged water, and 2 g of potassium hydroxide as a base substance were introduced into a 1000-ml container equipped with a stirring apparatus. Next, the temperature inside the container was heated to 50°C, and then the contained material was subjected to a hydrolysis treatment while being stirred, under the conditions of 24 hours. Thus, a solution including a crude imide group-containing compound was obtained.

Next, the solution including a crude imide group-containing compound was subjected to a series of processes of an acid treatment (phosphoric acid), water washing, an alkali treatment, and water washing repeatedly for five times, and thus the crude imide group-containing compound was purified to obtain a particulate imide group-containing compound (average particle size: 5 µm). Meanwhile, it was verified by a quantitative analysis that about 0.2% by weight of potassium, about 0.02% by weight of Si, about 0.02% by weight of Ca, and 0.005% by weight of Fe were respectively included in the particulate imide group-containing compound.

Next, 300 g of an aqueous solvent was held in a container equipped with a stirring apparatus, and then 100 g of a particulate (average particle size: 0.3 mm) imide group-containing compound was introduced therein. The mixture was stirred using a stirrer until a uniform aqueous solution of the imide group-containing compound was obtained. Next, 100 g of water as a diluent for the aqueous solution of an imide group-containing compound was additionally incorporated, and 8.2 g of triethyl ortho-formate as a viscosity stabilizer was introduced therein.

### (2) Step (2)

Next, a fluororesin-containing aqueous dispersion liquid was produced. That is, particles of a fluororesin (average particle size: 0.2 µm, referred to as fluororesin Type A) were mixed with a nonionic surfactant (1% by weight) such that the solid content became 60% by weight, and the mixture was uniformly mixed. Thereby, a fluororesin-containing aqueous dispersion liquid was obtained.

### (3) Step (3)

The imide group-containing compound thus obtained (solid content: about 20% by weight) and the fluororesin-containing aqueous dispersion liquid thus obtained (solid content: 60% by weight) were mixed, and the mixture was stirred slowly (5 to 50 rpm) with a propeller mixer until the mixture became uniform. Thus, an aqueous treatment agent was obtained. That is, an aqueous treatment agent was produced by incorporating the fluororesin-containing aqueous dispersion liquid such that the incorporation amount of the fluororesin-containing aqueous dispersion liquid would be a proportion of 5 parts by weight, in terms of solid content, with respect to 100 parts by weight of the imide group-containing compound, and using dimethylaminoethanol (boiling point: 134°C) as an amine compound (A1) such that the incorporation amount would be a proportion of 1 part by weight with respect to 100 parts by weight of the imide group-containing compound. On the occasion of incorporating the amine compound, it is preferable that the imide group-containing compound and the amine compound are mixed in advance before the fluororesin-containing aqueous dispersion liquid is incorporated, so that the imide group-containing compound can be dissolved more uniformly in the aqueous treatment agent. That is, it is because when the amine compound and the imide group-containing compound are mixed in advance, and the amine compound is caused to react with a carboxyl group carried by the imide group-containing compound, water-solubility of the imide group-containing compound thus obtained is further enhanced.

### (4) Step (4)

The aqueous treatment agent (black transparent liquid) thus obtained was laminated with a knife coater on the surface of a polyimide resin film (KAPTON H film, thickness 50 µm) as a material to be treated, such that the thickness after drying would be 10 µm.

### (5) Step (5)

Lastly, the aqueous treatment agent was laminated on the surface of a polyimide resin film as a material to be treated, and the laminate was left to stand for 1 to 24 hours at room temperature. Next, the laminate was subjected to a heating treatment (stage 1) using a circulation type heating oven under the heating conditions of 200°C and 30 minutes, and further to a heating treatment (stage 2) under the heating conditions of 280°C and 30 minutes, and thereby a polyimide resin film including a surface treatment film (thickness after drying: 10 µm) was obtained.

### 2. Evaluation of aqueous treatment agent

### (1) Aqueous solution stability (evaluation 1 /Eva 1)

The aqueous treatment agent thus obtained was left to stand under the conditions of 25°C and 3 months, and the aqueous solution stability was evaluated by visual inspection according to the following criteria.
⊙: The aqueous treatment agent was transparent, and no noticeable precipitate was observed.
○: The aqueous treatment agent was partially cloudy; however, no noticeable precipitate was observed.
Δ: The aqueous treatment agent was partially cloudy, and some noticeable precipitate was observed.
×: The aqueous treatment agent was cloudy, and a noticeable precipitate was observed.

### (2) External appearance (evaluation 2 / Eva 2)

The external appearance of the polyimide resin film including a surface treatment film thus obtained was evaluated by visual inspection according to the following criteria.
⊙ (Very Good) : The polyimide resin film is transparent, and the color and luster are very good.
○: (Good) The polyimide resin film is almost transparent, and the color and luster are good.
Δ: (Fair) The polyimide resin film is partially opaque, and the color and luster are slightly poor.
× : (Bad) The polyimide resin film is opaque, and the color and luster are poor.

### (3) Adhesiveness (evaluation 3 /Eva 3)

A cross-cut adhesion test was performed according to JIS K 5600, and for the polyimide resin film including a surface treatment film thus obtained, the adhesiveness between the surface treatment film and the polyimide resin film was evaluated according to the following criteria.
⊙ (Very Good) : The number of remaining cross-cut squares was 100 out of 100.
○ (Good) : The number of remaining cross-cut squares is 95 or more out of 100.
Δ (Fair) : The number of remaining cross-cut squares is 80 or more out of 100.
× (Bad) : The number of remaining cross-cut squares is fewer than 80 out of 100.

### (4) Water repellency (evaluation 4 /eva 4)

The surface tension (25°C) of the surface treatment film thus obtained was measured, and water repellency was evaluated according to the following criteria.
⊙ (Very Good) : The number of remaining cross-cut squares was 100 out of 100.
○ (Good) : The number of remaining cross-cut squares is 95 or more out of 100.
Δ (Fair) : The number of remaining cross-cut squares is 80 or more out of 100.
× (Bad) : The surface tension is above 40 mN/m.

### (5) Heat resistance (evaluation 5 / Eva 5)

Heating was performed (rate of temperature increase 10°C/min) from 30°C to 500°C under a nitrogen gas stream at a rate of 100 ml/min according to JIS K 7120 using a thermobalance (manufactured by Mettler Instruments AG, TG-DTA analyzer), and a TG-DTA curve was obtained. Then, based on the TG curve in the TG-DTA curve, an evaluation of the heat resistance of the polyimide resin film including a surface treatment film thus obtained was performed according to the following criteria.
⊙ (Very Good) : The 10% weight reduction temperature is 250°C or higher.
○ (Good) : The 10% weight reduction temperature is 200°C or higher.
Δ (Fair) : The 10% weight reduction temperature is 150°C or higher.
× (Bad) : The 10% weight reduction temperature is below 150°C.

### [Example 2]

In Example 2, an aqueous treatment agent (black transparent liquid) was produced such that the incorporation amount of a fluororesin (Type A) included in the fluororesin-containing aqueous dispersion liquid would be 10 parts by weight, in terms of solid content, and the incorporation amount of the amine compound would be 5 parts by weight, with respect to 100 parts by weight of the imide group-containing compound of the imide group-containing compound, and evaluation was performed in the same manner as in Example 1.

### [Example 3]

In Example 3, an aqueous treatment agent (black transparent liquid) was produced such that the incorporation amount of the fluororesin (Type A) included in the fluororesin-containing aqueous dispersion liquid would be 30 parts by weight, in terms of solid content, and the incorporation amount of the amine compound would be 10 parts by weight, with respect to 100 parts by weight of the imide group-containing compound of the imide group-containing compound, and evaluation was performed in the same manner as in Example 1.

### [Example 4]

In Example 4, an aqueous treatment agent (black transparent liquid) was produced such that the incorporation amount of the fluororesin (Type A) included in the fluororesin-containing aqueous dispersion liquid would be 50 parts by weight, in terms of solid content, and the incorporation amount of the amine compound would be 20 parts by weight, with respect to 100 parts by weight of the imide group-containing compound of the imide group-containing compound, and evaluation was performed in the same manner as in Example 1.

### [Example 5]

In Example 5, an aqueous treatment agent (black transparent liquid) was produced such that the incorporation amount of a fluororesin (Type A) included in the fluororesin-containing aqueous dispersion liquid would be 70 parts by weight, in terms of solid content, and the incorporation amount of the amine compound would be 20 parts by weight, with respect to 100 parts by weight of the imide group-containing compound of the imide group-containing compound, and evaluation was performed in the same manner as in Example 1.

### [Example 6]

In Example 6, an aqueous treatment agent (black transparent liquid) was produced in the same manner as in Example 4, except that the average particle size of the fluororesin included in the fluororesin-containing aqueous dispersion liquid was adjusted to 0.1 µm (referred to as fluororesin Type B), and the incorporation amount of the fluororesin was adjusted to 150 parts by weight, and the aqueous treatment agent was evaluated.

### [Example 7]

In Example 7, an aqueous treatment agent (black transparent liquid) was produced in the same manner as in Example 4, except that the average particle size of the fluororesin included in the fluororesin-containing aqueous dispersion liquid was adjusted to 0.5 µm (referred to as fluororesin Type C), the incorporation amount of the fluororesin was adjusted to 300 parts by weight, and the type of the amine compound was changed to triethylamine (referred to as amine compound A2). Thus, the aqueous treatment agent was evaluated.

### [Example 8]

In Example 8, an aqueous treatment agent (pale yellow transparent liquid) was produced in the same manner as in Example 4, except that the average particle size of the fluororesin included in the fluororesin-containing aqueous dispersion liquid was adjusted to 2.0 µm (referred to as fluororesin Type D), the incorporation amount of the fluororesin was adjusted to 1,000 parts by weight, and the type of the amine compound was changed to morpholine (referred to as amine compound A3). Thus, the aqueous treatment agent was evaluated.

### [Comparative Example 1]

In Comparative Example 1, the fluororesin-containing aqueous dispersion liquid was not at all incorporated into 100 parts by weight of the imide group-containing compound. That is, evaluation was performed in the same manner as in Example 3, except that an aqueous treatment agent (black transparent liquid) including 0 parts by weight, in terms of solid content, of the fluororesin-containing aqueous dispersion liquid was produced.

### [Comparative Example 2]

In Comparative Example 2, evaluation was performed in the same manner as in Example 4, except that an aqueous treatment agent (pale black transparent liquid) was produced such that the incorporation amount of the fluororesin-containing aqueous dispersion liquid including the fluororesin Type A was 10,500 parts by weight with respect to 100 parts by weight of the imide group-containing compound, in terms of solid content.

**[Table 1]**

| | Material to be treated | Imide group-containing compound | FluoroResin | Amine | Eva1 | Eva2 | Eva3 | Eva4 | Eva5 |
|---|---|---|---|---|---|---|---|---|---|
| Example 1 | PI | 100 | Type A | A1 | ⊙ | ⊙ | ⊙ | ○ | ⊙ |
| | | | 5 | 1 | | | | | |
| Example 2 | PI | 100 | Type A | A1 | ⊙ | ⊙ | ⊙ | ⊙ | ⊙ |
| | | | 10 | 5 | | | | | |
| Example 3 | PI | 100 | Type A | A1 | ⊙ | ⊙ | ⊙ | ⊙ | ⊙ |
| | | | 30 | 10 | | | | | |
| Example 4 | PI | 100 | Type A | A1 | ⊙ | ⊙ | ⊙ | ⊙ | ⊙ |
| | | | 50 | 20 | | | | | |
| Example 5 | PI | 100 | Type A | A1 | ⊙ | ⊙ | ○ | ⊙ | ⊙ |
| | | | 70 | 20 | | | | | |
| Example 6 | PI | 100 | Type B | A1 | ⊙ | ⊙ | ○ | ⊙ | ⊙ |
| | | | 150 | 20 | | | | | |
| Example 7 | PI | 100 | Type C | A2 | ⊙ | ○ | ○ | ⊙ | ○ |
| | | | 300 | 20 | | | | | |
| Example 8 | PI | 100 | Type D | A3 | ○ | ○ | ○ | ⊙ | ○ |
| | | | 1000 | 20 | | | | | |
| Comparative Example 1 | PI | 100 | ○ | A1 | ⊙ | ⊙ | ⊙ | × | ⊙ |
| | | | | 10 | | | | | |
| Comparative Example 2 | PI | 100 | Type A | A1 | Δ | Δ | Δ | ○ | ○ |
| | | | 10500 | 20 | | | | | |

| | | | | | | | | | |
|---|---|---|---|---|---|---|---|---|---|
| Eva 1: Aqueous solution stability Eva 2: External appearance Eva 3: Adhesiveness (cross-cut adhesion test) Eva 4: Water repellency Eva 5: Heat resistance | | | | | | | | | |

### [Examples 9 and 10]

In Examples 9 and 10, aqueous treatment agents were produced in the same manner as in Example 4 and Example 5, respectively, except that a 100-µm fluororesin film was used as the material to be treated, instead of a polyimide resin film (KAPTON H film, thickness 50 µm) or the like. The aqueous treatment agents were applied to the fluororesin film, and evaluation as composite films was performed. As a result, as shown in Table 2, in a case in which a fluororesin film (PF) was used as the material to be treated, the results of Evaluations 1 to 5 were obtained for Examples 9 and 10. Furthermore, although not shown in Table 2, in Examples 9 and 10, the ultraviolet transmittance (wavelength 375 nm) of the composite films thus obtained respectively was measured using an ultraviolet transmittance meter as Evaluation 6, and the transmittance was 0%.

### [Examples 11 and 12]

In Example 11 and 12, aqueous treatment agents were produced in the same manner as in Example 4 and Example 5, respectively, except that a 100-µm polyester film (manufactured by Toray Co., Ltd., LUMIRROR) was used as the material to be treated, instead of the polyimide resin film (KAPTON H film, thickness 50 µm) or the like. The aqueous treatment agents were applied to the polyester film, and evaluation as composite films was performed. As a result, as shown in Table 2, in a case in which a polyester film (PET) was used as the material to be treated, the results of Evaluations 1 to 5 were obtained for Examples 11 and 12. Furthermore, although not shown in Table 2, in Examples 11 and 12, the ultraviolet transmittance (wavelength 375 nm) of the composite films thus obtained respectively was measured using an ultraviolet transmittance meter as Evaluation 6, and the transmittance was 0%.

### [Comparative Example 3]

In Comparative Example 3, the fluororesin-containing aqueous dispersion liquid was not at all incorporated into 100 parts by weight of the imide group-containing compound. That is, evaluation was performed in the same manner as in Example 8 for the fluororesin film as the material to be treated, except that an aqueous treatment agent (black transparent liquid) including 0 parts by weight, in terms of solid content, was produced. Furthermore, although not shown in Table 2, in Comparative Example 3, the ultraviolet transmittance (wavelength 375 nm) of the composite film thus obtained was measured using an ultraviolet transmittance meter as Evaluation 6, and the transmittance was 70%.

### [Comparative Example 4]

In Comparative Example 4, the fluororesin-containing aqueous dispersion liquid was not at all incorporated into 100 parts by weight of the imide group-containing compound. That is, evaluation was performed in the same manner as in Example 8 for the polyester film as the material to be treated, except that an aqueous treatment agent (black transparent liquid) including 0 parts by weight, in terms of solid content, was produced. Furthermore, although not shown in Table 2, in Comparative Example 4, the ultraviolet transmittance (wavelength 375 nm) of the composite film thus obtained was measured using an ultraviolet transmittance meter as Evaluation 6, and the transmittance was 98%.

**[Table 2]**

| | Material to be treated | Imide-containing compound | Fluoro-Resin | Amine | Eva1 | Eva2 | Eva3 | Eva4 | Eva5 |
|---|---|---|---|---|---|---|---|---|---|
| Example 9 | PF | 100 | Type A | A1 | ⊙ | ⊙ | ⊙ | ⊙ | ○ |
| | | | 50 | 20 | | | | | |
| Example 10 | PF | 100 | Type A | A1 | ⊙ | ⊙ | ⊙ | ⊙ | ○ |
| | | | 70 | 20 | | | | | |
| Example 11 | PET | 100 | Type A | A1 | ⊙ | ⊙ | ⊙ | ○ | ○ |
| | | | 50 | 20 | | | | | |
| Example 12 | PET | 100 | Type A | A2 | ⊙ | ⊙ | ⊙ | ⊙ | ○ |
| | | | 70 | 20 | | | | | |
| Comparative Example 3 | PF | 100 | None | A3 | ⊙ | ⊙ | ⊙ | × | × |
| | | | | 20 | | | | | |
| Comparative Example 4 | PET | 100 | None | A3 | ⊙ | ⊙ | ⊙ | × | × |
| | | | | 20 | | | | | |

| | | | | | | | | | |
|---|---|---|---|---|---|---|---|---|---|
| Eva 1: Aqueous solution stability Eva 2: External appearance Eva 3: Adhesiveness (cross-cut adhesion test) Eva 4: Water repellency Eva 5: Heat resistance | | | | | | | | | |

### INDUSTRIAL APPLICABILITY

As described above, according to the present invention, an aqueous treatment agent having excellent environmental safety and aqueous solution stability could be supplied, by means of an aqueous treatment agent formed by mixing, at predetermined proportions, an imide group-containing compound obtainable by partially hydrolyzing a polyimide molded article as an industrial waste or the like, the imide group-containing compound having a particular structure having predetermined absorption peaks in an infrared spectroscopic spectral chart, with a predetermined fluororesin-containing aqueous dispersion liquid. Furthermore, when the aqueous treatment agent thus obtained is used, due to the phase separation in a critical way between a polyimide resin and a fluororesin, a thermally cured polyimide resin-rich layer can be formed on one of the surfaces of a surface treatment film, and a fluororesin-rich layer that has undergone crystallization or the like can be formed on the surface of the opposite side, and thus a surface treatment film in which a polyimide resin-rich layer and a fluororesin-rich layer are strongly bonded, can be provided. Therefore, by utilizing the polyimide resin-rich layer and the fluororesin-rich layer, the aqueous treatment film could exhibit satisfactory adhesiveness to various materials to be treated, including a polyimide resin molded article and a fluororesin molded article, and a surface treatment intended for imparting heat resistance, imparting mechanical characteristics resistance, imparting ultraviolet resistance, imparting chemical resistance, and the like could be reliably provided.

Furthermore, it was verified that the aqueous treatment agent thus obtained has excellent storage stability even in a solution state, and as considered from the viscosity increase, (within about 3 times the initial value), it was verified that the aqueous treatment agent has a shelf life of at least three months or longer not only at room temperature but also at a temperature of 40°C. Therefore, it is expected that the aqueous treatment agent thus obtained is widely applied to various materials to be treated, as an aqueous treatment agent having excellent environmental safety and aqueous solution stability and including an inexpensive (the price being 1/10 to 1/2 of the price of a polyimide resin as a non-recycled article) imide group-containing compound.

### EXPLANATIONS OF LETTERS OR NUMERALS

10 SURFACE TREATMENT FILM
10a, 10a' FLUORORESIN-RICH LAYER
10b, 10b' POLYIMIDE RESIN-RICH LAYER
10c POLYIMIDE FILM
10' POLYIMIDE FILM FOR SINGLE-SIDED HIGH-FREQUENCY CIRCUIT
10" POLYIMIDE FILM FOR DOUBLE-SIDED HIGH-FREQUENCY CIRCUIT
12 PREDETERMINED FUNCTIONAL FILM (METAL LAYER)
12a PRIMER LAYER
14 SINGLE-SIDED HIGH-FREQUENCY CIRCUIT BOARD
50 MATERIAL TO BE TREATED
52 SURFACE TREATMENT FILM
53 COLORING LAYER
53a COLORANT MATERIAL
53b RESIN LAYER FOR COLORANT MATERIAL DISPERSION
54 OVERCOAT LAYER
60 METAL MOLDED ARTICLE INCLUDING FLUORORESIN LAYER

## Claims

1. An aqueous treatment agent, comprising an imide group-containing compound obtained by partially hydrolyzing a polyimide molded article; a fluororesin-containing aqueous dispersion liquid; and an amine compound,
wherein the fluororesin-containing aqueous dispersion liquid is incorporated such that an incorporation amount of a fluororesin included in the fluororesin-containing aqueous dispersion liquid is adjusted to a value within the range of 0.1 to 10,000 parts by weight, in terms of solid content, with respect to 100 parts by weight of the imide group-containing compound, and an incorporation amount of the amine compound is adjusted to a value within the range of 0.1 to 30 parts by weight with respect to 100 parts by weight of the imide group-containing compound.

2. The aqueous treatment agent according to claim 1, wherein a boiling point of the amine compound is adjusted to a value within the range of 50°C to 350°C.

3. The aqueous treatment agent according to claim 1 or 2, wherein the fluororesin-containing aqueous dispersion liquid includes particles of the fluororesin, and the average particle size of the fluororesin particles is adjusted to a value within the range of 0.01 to 10 µm.

4. The aqueous treatment agent according to any one of claims 1 to 3, wherein the fluororesin-containing aqueous dispersion liquid includes a surfactant, and an incorporation amount of the surfactant is adjusted to a value within the range of 0.01% to 10% by weight with respect to the total amount of the fluororesin-containing aqueous dispersion liquid.

5. The aqueous treatment agent according to any one of claims 1 to 4, wherein the imide group-containing compound has, in an infrared spectroscopic spectral chart obtainable in the case of analyzing the imide group-containing compound by infrared spectroscopy, an absorption peak originating from an imide group at a wave number of 1,375 cm⁻¹, an absorption peak originating from an amide group at a wave number of 1,600 cm⁻¹, and an absorption peak originating from a carboxyl group at a wave number of 1,413 cm⁻¹.

6. The aqueous treatment agent according to any one of claims 1 to 5, wherein the imide group-containing compound includes at least one of an ortho-formic acid ester compound, a phytic acid compound, a Dacrotized compound, and EDTA as a viscosity stabilizer, and an incorporation amount of the viscosity stabilizer is adjusted to a value within the range of 0.01% to 20% by weight with respect to the total amount of the imide group-containing compound.

7. A method for producing an aqueous treatment agent including an imide group-containing compound obtained by partially hydrolyzing a polyimide molded article; a fluororesin-containing aqueous dispersion liquid; and an amine compound, the method comprising the following steps (1) to (3) :
(1) a step of incorporating an aqueous solvent in an amount adjusted to a value within the range of 0.1 to 30 parts by weight with respect to 100 parts by weight of the imide group-containing compound, and incorporating an amine compound in an amount adjusted to a value within the range of 0.1 to 30 parts by weight with respect to 100 parts by weight of the imide group-containing compound as a first solution;
(2) a step of preparing a fluororesin-containing aqueous dispersion liquid as a second solution; and
(3) a step of mixing the first solution and the second solution such that an incorporation amount of a fluororesin included in the second solution is adjusted to a value within the range of 0.1 to 10,000 parts by weight, in terms of solid content, with respect to 100 parts by weight of the imide group-containing compound included in the first solution, and obtaining an aqueous treatment agent.

8. A method for using an aqueous treatment agent including an imide group-containing compound obtained by partially hydrolyzing a polyimide molded article; a fluororesin-containing aqueous dispersion liquid; and an amine compound, the method comprising the following steps (1') to (3') :
(1') a step of preparing an aqueous treatment agent including an imide group-containing compound obtained by partially hydrolyzing a polyimide molded article, and a fluororesin-containing aqueous dispersion liquid, by adjusting an incorporation amount of a fluororesin included in the fluororesin-containing aqueous dispersion liquid to a value within the range of 0.1 to 10,000 parts by weight, in terms of solid content, with respect to 100 parts by weight of the imide group-containing compound, and adjusting the incorporation amount of the amine compound to a value within the range of 0.1 to 30 parts by weight with respect to 100 parts by weight of the imide group-containing compound;
(2') a step of laminating the aqueous treatment agent on the surface of a material to be treated; and
(3') a step of heating the aqueous treatment agent laminated on the surface of the material to be treated, to a temperature of 200°C or higher, and thereby obtaining a surface treatment film.
